(19) Europäisches Patentamt
European Patent Office
Office européen des brevets

(11) **EP 2 939 046 B1**

## (12) FASCICULE DE BREVET EUROPEEN

(45) Date de publication et mention de la délivrance du brevet:
**08.09.2021 Bulletin 2021/36**

(21) Numéro de dépôt: **13814982.8**

(22) Date de dépôt: **24.12.2013**

(51) Int Cl.:
*G01R 33/46* [(2006.01)]    *G01R 33/465* [(2006.01)]
*G01N 24/08* [(2006.01)]    *G01R 33/3415* [(2006.01)]

(86) Numéro de dépôt international:
**PCT/EP2013/078007**

(87) Numéro de publication internationale:
**WO 2014/102293 (03.07.2014 Gazette 2014/27)**

### (54) ANALYSE PAR RMN D'UN ÉCHANTILLON COMPRENANT UNE ESPÈCE À CARACTÉRISER ET UNE ESPÈCE DE RÉFÉRENCE

KERNSPINRESONANZ-ANALYSE EINER PROBE, DIE EINE ZU CHARAKTERISIERENDE SPEZIES UND EINE REFERENZ-SPEZIES UMFASST

NMR ANALYSIS OF A SAMPLE COMPRISING A SPECIES TO BE CHARACTERIZED AND A REFERENCE SPECIES

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **28.12.2012 FR 1262964**

(43) Date de publication de la demande:
**04.11.2015 Bulletin 2015/45**

(73) Titulaires:
- **Universite d'Aix Marseille
  13284 Marseille Cedex 07 (FR)**
- **Centre National de la Recherche Scientifique
  75016 Paris (FR)**

(72) Inventeur: **LE FUR, Yann
F-13005 Marseille (FR)**

(74) Mandataire: **Hautier, Nicolas
Cabinet Hautier
20, rue de la Liberté
06000 Nice (FR)**

(56) Documents cités:
**US-A1- 2004 095 139    US-A1- 2008 204 022**

- **STEFAN REUTTER ET AL: "Compensation of Magnetic Field Instabilities in Field Cycling NMR by Reference Deconvolution", APPLIED MAGNETIC RESONANCE, SPRINGER VIENNA, VIENNA, vol. 44, no. 1 - 2, 5 octobre 2012 (2012-10-05), pages 55-63, XP035167236, ISSN: 1613-7507, DOI: 10.1007/S00723-012-0396-8**
- **MESQUITA SOUSA D ET AL: "Desktop fast-field cycling nuclear magnetic resonance relaxometer", SOLID STATE NUCLEAR MAGNETIC RESONANCE, ELSEVIER SCIENCE BV., AMSTERDAM, NL, vol. 38, no. 1, 16 juillet 2010 (2010-07-16), pages 36-43, XP027218888, ISSN: 0926-2040 [extrait le 2010-07-16]**
- **ÖZDEMIR M S ET AL: "Quantitative proton magnetic resonance spectroscopy without water suppression", JOURNAL OF INSTRUMENTATION, INSTITUTE OF PHYSICS PUBLISHING, BRISTOL, GB, vol. 4, no. 6, 22 septembre 2007 (2007-09-22), page P06014, XP020162945, ISSN: 1748-0221**
- **POULLET J B ET AL: "MRS signal quantitation: A review of time- and frequency-domain methods", JOURNAL OF MAGNETIC RESONANCE, ACADEMIC PRESS, ORLANDO, FL, US, vol. 195, no. 2, 11 septembre 2008 (2008-09-11), pages 134-144, XP025626033, ISSN: 1090-7807, DOI: 10.1016/J.JMR.2008.09.005 [extrait le 2008-09-11]**

- GONEN O ET AL: "SOLVENT SUPPRESSION BY SELECTIVE SIGNAL SUBTRACTION, A TIME-DOMAIN NEGATIVE-FEEDBACK DYNAMIC-RANGE-COMPRESSION METHOD FOR PROTON NMR SPECTROSCOPY", JOURNAL OF MAGNETIC RESONANCE. SERIES B, ACADEMIC PRESS, ORLANDO, FL, US, vol. 102, no. 1, 1 août 1993 (1993-08-01), pages 98-102, XP000384638, ISSN: 1064-1866, DOI: 10.1006/JMRB.1993.1068
- JIRU ET AL: "Introduction to post-processing techniques", EUROPEAN JOURNAL OF RADIOLOGY, ELSEVIER SCIENCE, NL, vol. 67, no. 2, 1 août 2008 (2008-08-01), pages 202-217, XP023315973, ISSN: 0720-048X, DOI: 10.1016/J.EJRAD.2008.03.005 [extrait le 2008-04-23]
- SKOCH A ET AL: "Spectroscopic imaging: Basic principles", EUROPEAN JOURNAL OF RADIOLOGY, ELSEVIER SCIENCE, NL, vol. 67, no. 2, 1 août 2008 (2008-08-01), pages 230-239, XP023315975, ISSN: 0720-048X, DOI: 10.1016/J.EJRAD.2008.03.003 [extrait le 2008-04-22]
- DONG ET AL: "The rapid and automatic combination of proton MRSI data using multi-channel coils without water suppression", MAGNETIC RESONANCE IMAGING, ELSEVIER SCIENCE, TARRYTOWN, NY, US, vol. 25, no. 8, 27 septembre 2007 (2007-09-27), pages 1148-1154, XP022275291, ISSN: 0730-725X, DOI: 10.1016/J.MRI.2007.01.005
- None

**Description**

DOMAINE TECHNIQUE DE L'INVENTION

La présente invention concerne en général les techniques de résonance magnétique nucléaire (RMN) utilisées notamment pour l'analyse d'un échantillon. La présente invention s'applique avantageusement au domaine de la médecine pour l'analyse d'échantillons biologiques du corps humain par exemple ou au domaine de la chimie pour l'analyse de compositions chimiques. Elle s'avère particulièrement avantageuse pour corriger la phase et/ou la fréquence d'un signal de décroissance libre d'induction (FID). Dans une application avantageuse mais non limitative, l'invention sera utilisée pour recombiner efficacement des signaux RMN détectés par des réseaux d'antennes.

ÉTAT DE LA TECHNIQUE

Découverte dans les années quarante, la résonance magnétique nucléaire (RMN) a pris une importance considérable dans de nombreux domaines scientifiques pour l'analyse de matériaux et particulièrement en médecine pour l'observation in vivo du corps humain. De très nombreuses applications de cette découverte ont été mises en oeuvre. Dans le domaine médical, il s'agit notamment de l'imagerie par résonance magnétique ou IRM et de la spectroscopie RMN qui permet d'analyser la composition des tissus du corps humain. Dans le cadre de la présente invention, on utilisera de manière interchangeable les termes spectroscopie et spectrométrie, techniques qui permettent d'identifier et/ou de quantifier la teneur d'espèces dans un échantillon.

La résonance magnétique nucléaire est un phénomène complexe qui n'est décrit complètement que par les lois de la physique quantique. Pour ce qui est de la compréhension de l'invention et de l'état de la technique il est cependant suffisant de connaître les phénomènes principaux mis en œuvre par la RMN et très brièvement rappelés ci-après. On notera ici qu'il existe une très abondante littérature technique sur tous les aspects de la RMN.

Placés dans un fort champ magnétique, traditionnellement noté B0, généralement de l'ordre du tesla (T) et plus, certains atomes acquièrent des propriétés particulières telles que s'ils sont perturbés par une onde radio de fréquence adaptée ils renvoient alors un signal que l'on peut analyser.

Les atomes concernés sont ceux qui possèdent un noyau atomique ayant un moment magnétique ou spin non nul. Dans le domaine médical, l'hydrogène (H) de l'eau ($H_2O$) qui constitue la majeure partie du corps humain possède cette propriété. La molécule d'eau possède deux noyaux d'hydrogène ou protons ayant un spin non nul animés d'un mouvement de précession de leur axe à une fréquence particulière dite fréquence de Larmor. Placés dans un fort champ magnétique statique extérieur les noyaux voient alors leur spin s'orienter soit dans la direction du champ magnétique extérieur, soit dans la direction opposée tout en subissant un mouvement de précession à la fréquence de Larmor dépendant de l'intensité du champ extérieur B0. Pour les noyaux d'hydrogène, la fréquence de Larmor s'accroît de 42 MHz (mégahertz = $10^6$ hertz) par tesla. Elle est par exemple proche de 4 MHz à 0,1 T ; 64 MHz à 1,5 T et 600 MHz à 14 T.

Les noyaux peuvent alors être perturbés par une onde radio ou radiofréquence (RF) d'autant plus facilement que la fréquence de celle-ci est proche de la fréquence de Larmor et donc de préférence en résonance avec cette dernière. La perturbation a pour effet de changer l'orientation du spin jusqu'à possiblement le faire basculer dans l'autre direction permise par le champ magnétique extérieur B0. C'est-à-dire que l'orientation est parallèle ou antiparallèle à celui-ci et passe ainsi de l'une à l'autre. Traditionnellement noté B1, l'induction magnétique de l'onde radio perturbatrice est appliquée perpendiculairement à celle de B0 pour faire basculer le spin des noyaux. C'est ce basculement et le retour à l'équilibre ou relaxation qui génère le signal électrique détecté dans tous les équipements RMN. Ce signal est habituellement qualifié de FID de l'anglais « free induction decay » c'est-à-dire « décroissance libre de l'induction ».

La perturbation électromagnétique B1 est appliquée à l'aide de bobines électriques le plus souvent qualifiées d'antennes. Les bobines ou antennes servent en général aussi bien à appliquer la perturbation qu'à détecter les signaux électriques engendrés lors du retour à l'équilibre des noyaux. Pour ce faire, elles sont associées d'une part à des circuits électroniques qui vont permettre d'y faire circuler pendant un temps contrôlé un courant électrique à la fréquence de Larmor, ce qui va générer dans la zone du corps à analyser l'onde électromagnétique et le champ perturbateur B1, et d'autre part à des circuits électroniques qui vont permettre de détecter les signaux électriques engendrés par le retour à l'équilibre des noyaux après que l'on a interrompu la perturbation électromagnétique. On notera ici que les signaux électriques qu'il faut pouvoir détecter avec ces antennes sont généralement faibles voire très faibles et que l'enjeu est de pouvoir les distinguer du niveau de bruit intrinsèque à l'équipement électrique utilisé. Le rapport signal sur bruit (RSB) est le critère clé de la partie détection électrique de tout équipement RMN. Il doit être suffisamment élevé pour que les signaux détectés le soient à un niveau au-dessus du bruit qui les rend exploitables par l'application considérée.

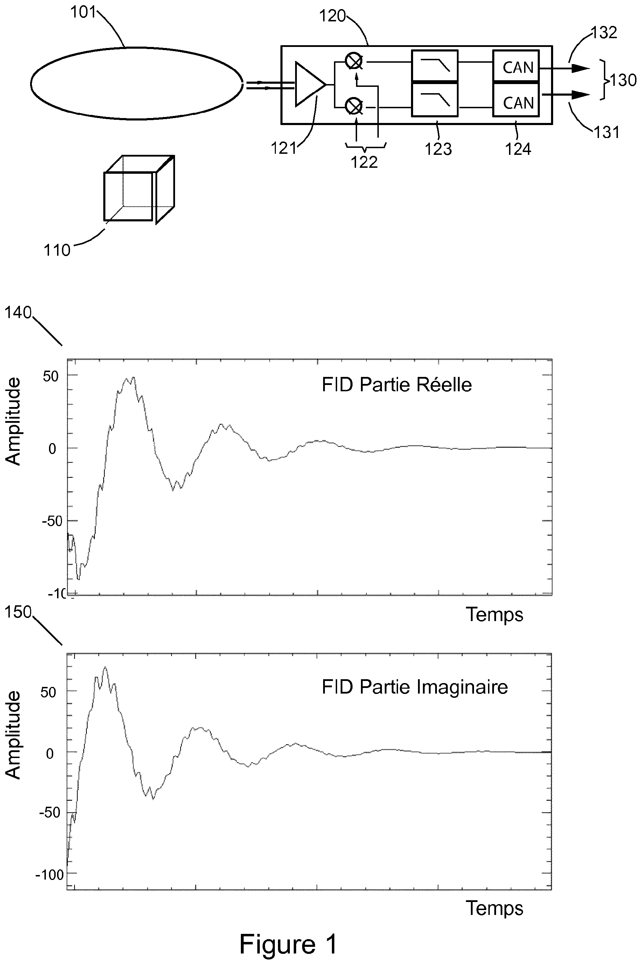

Comme cela sera décrit en détail par la suite en référence à la figure 1, les techniques connues consistent à effectuer une transformée de Fourier du signal complexe de FID pour obtenir une répartition spectrale de l'échantillon. Cette répartition spectrale permet de comparer la fréquence et l'amplitude d'un signal de référence par rapport à celles des signaux des métabolites à caractériser.

Le signal de référence correspond le plus souvent à une espèce majoritaire dans l'échantillon. Pour l'analyse d'un échantillon biologique, le signal de référence est typiquement le signal de l'eau.

La comparaison de la fréquence et de l'amplitude du signal de l'eau par rapport à celles des signaux des métabolites à caractériser permet d'identifier la nature et la teneur des métabolites dans l'échantillon.

Cette technique est globalement satisfaisante. Elle requiert néanmoins que le signal de référence acquis soit correctement positionné, en phase et en fréquence par rapport à une position théorique. On dit alors que le signal de référence doit être « en résonance ». Pour cela, il faut régler la fréquence de conversion du récepteur, typiquement une bobine, exactement sur la fréquence de résonance du signal de référence.

Or, de nombreux paramètres tendent à faire apparaître un glissement en fréquence qui éloigne le signal de référence acquis de sa position théorique.

Comme cela sera détaillé par la suite, ce glissement est au moins en partie dû à la différence qui existe en pratique entre la fréquence de démodulation utilisée par le récepteur et la fréquence effective du signal de référence.

Ainsi, les techniques connues nécessitent de corriger manuellement la phase et la fréquence du signal complexe de FID avant son exploitation. Ces étapes de correction sont relativement longues et fastidieuses.

Par ailleurs, une autre opération de correction manuelle consiste à rephaser le signal de référence. En effet, en pratique il y a forcément un décalage aléatoire entre la phase du signal utilisé par le récepteur et la phase du signal de référence. Cela se traduit, sur une représentation d'un signal complexe de FID, par le fait que le premier point de la FID n'est en général pas réel.

En outre, dans les cas où l'on acquiert des signaux provenant de plusieurs entités volumétriques de l'échantillon, habituellement désignées voxels, l'inhomogénéité du champ B0 tend également à entraîner des déphasages et des décalages en fréquence.

Par ailleurs, des déphasages et décalages en fréquence sont également générés par l'utilisation de multiples antennes. En effet, au cours de décennies de développement les structures d'antennes ont beaucoup évoluées et la recherche et le développement des équipements RMN tendent maintenant à favoriser l'emploi, pour l'analyse d'une zone donnée du corps humain, d'antennes multiples. Ces antennes multiples sont généralement identiques et de petites tailles et on combine les signaux détectés séparément dans le but d'obtenir un signal composite qui a notamment un meilleur RSB que s'il avait été obtenu avec une seule antenne couvrant la même zone d'analyse. Par ailleurs, l'utilisation d'une pluralité d'antennes permet généralement d'augmenter la rapidité de l'acquisition, tout en conservant un bon RSB, ce qui s'avère primordiale lorsque l'échantillon fait partie d'un corps vivant et donc bien souvent non parfaitement immobile. Ce type d'antennes dites « antennes en réseau phasé » traduction de l'anglais « phased array antenna » se caractérise par une complexité notablement accrue de la partie électronique et du traitement informatique des signaux produits séparément par chacune des antennes du réseau. Il faut en effet pouvoir les recombiner efficacement en dépit des inévitables différences géométriques, physiques et électriques qui existent entre antennes et qu'il faut pouvoir compenser pour effectivement obtenir les améliorations attendues du réseau d'antennes. Le document US 2004/0095139 décrit une solution pour recombiner des signaux de FID provenant de plusieurs bobines.

Le document suivant STEFAN REUTTER ET AL, "Compensation of Magnetic Field Instabilities in Field Cycling NMR by Reference Deconvolution", APPLIED MAGNETIC RESONANCE, SPRINGER VIENNA, VIENNA, (20121005), vol. 44, no. 1 - 2, doi:10.1007/S00723-012-0396-8, ISSN 1613-7507, pages 55 - 63, concerne une technique de relaxométrie, technique qui ne vise pas à identifier ou quantifier des espèces dans un échantillon mais à mesurer le temps de relaxation d'une espèce préalablement identifiée, le plus souvent à l'état pur dans une solution ou dans une solution comprenant un dopant qui ne présente pas de fréquence de résonance et qui ne produit donc pas de signal. Ce document décrit une expérience dans laquelle l'échantillon ne comprend qu'une seule espèce qui présente une seule fréquence de résonance.

Le document US2008204022 utilise le signal de RMN de façon parfaitement fait standard. Ainsi le spectre est obtenu par une transformation de Fourier de la FID complexe.

Le document MESQUITA SOUSA D ET AL, "Desktop fast-field cycling nuclear magnetic resonance relaxometer", SOLID STATE NUCLEAR MAGNETIC RESONANCE, ELSEVIER SCIENCE BV., AMSTERDAM, NL, vol. 38, no. 1, ISSN 0926-2040, (20100716), pages 36 - 43, (20100716) décrit également des techniques classiques de relaxométrie.

Il serait particulièrement avantageux d'améliorer le RSB des signaux obtenus, par rapport aux méthodes connues.

Il serait en outre particulièrement avantageux, de proposer une solution pour améliorer la recombinaison des signaux RMN détectés séparément par une ou plusieurs antennes sans pour autant complexifier lourdement les équipements connus.

Un autre avantage consiste à proposer une solution pour simplifier la complexité des équipements de RMN, notamment ceux utilisant plusieurs bobines réceptrices.

Les autres objets, caractéristiques et avantages de la présente invention apparaîtront à l'examen de la description suivante et des dessins d'accompagnement. Il est entendu que d'autres avantages peuvent être incorporés.

RÉSUMÉ DE L'INVENTION

Selon un mode de réalisation, l'invention porte sur un procédé d'analyse spectroscopique selon la revendication 1.

Les signaux complexes de décroissance libre d'induction (FID) comprennent chacun des données relatives à l'espèce de référence. Ainsi, avant génération du module de FID, le procédé selon l'invention conserve le signal de l'espèce de référence. De préférence, l'invention ne prévoit donc pas de suppression complète de l'espèce de référence avant extraction du module de la FID. Une suppression partielle est possible, mais il faut néanmoins que l'amplitude du signal de l'espèce de référence soit au moins supérieure à deux fois l'amplitude du signal de l'espèce à caractériser avant extraction du module de la FID.

Le signal de l'espèce de référence fait ainsi office de porteuse pour les signaux des espèces à caractériser. L'information de phase des signaux des espèces à caractériser est ainsi conservée malgré la prise en compte du module.

Ainsi, avec l'invention, à partir du moment où l'on acquiert un signal de l'espèce de référence, typiquement le signal de l'eau, on peut se passer des parties réelles et imaginaires. Ensuite, après avoir corrigé la phase du signal par prise en compte du module, on peut supprimer ou atténuer fortement le signal de l'espèce de référence.

En appliquant la méthode selon l'invention, on obtient un spectre symétrique de part et d'autre de la fréquence correspondant à celle de l'espèce majoritaire, typiquement de l'eau lorsque l'échantillon est un tissu biologique.

Bien qu'une partie des informations captées par les antennes (l'information de phase) soit éliminée lors de la prise en compte du module de la FID, le ratio signal sur bruit du signal (RSB) final demeure parfaitement satisfaisant. Dans le cadre de développement de la présente invention, on s'attendait en effet à ce que cette perte d'information conduise à une baisse trop pénalisante du RSB. L'obtention d'un RSB très satisfaisant provient vraisemblablement du fait que la perte d'information est largement compensée par l'élimination automatique des décalages en phase et en fréquence que permet la séquence d'étapes selon l'invention avec prise en compte du module sur un signal présentant une porteuse et des signaux plus faibles représentatifs des espèces à caractériser. L'invention permet en effet de corriger automatiquement les décalages en phase et en fréquence dus notamment aux mouvements de l'échantillon durant la durée de la FID, aux inhomogénéités du champ B0 et aux inévitables variations de comportement des différentes antennes dans le cadre d'une acquisition par plusieurs antennes.

Ainsi, le spectre obtenu permet d'identifier et de caractériser très aisément les espèces de l'échantillon.

De manière particulièrement avantageuse, l'invention permet également de se passer d'étapes supplémentaires spécialement dédiées aux corrections de phase et de fréquence, ces étapes nécessitant habituellement un temps de traitement significatif, voire bien souvent l'intervention manuelle d'un opérateur.

En outre, la quantité de données à traiter est moitié de celles qu'il faut traiter de façon conventionnelle où l'on a besoin du signal complexe pour calculer le déphasage du signal. De plus le calcul du module peut être effectué dans le domaine réel puisqu'il suffit de prendre la racine carré de la somme de deux nombres, chacun élevé au carré, alors que le calcul de la phase nécessite de travailler avec des nombres complexes, ce qui est plus difficile à mettre en oeuvre. Le temps et le coût du traitement sont donc considérablement réduits, et le fait que l'intervention manuelle d'un opérateur ne soit plus requise permet d'effectuer un traitement automatique en temps réel sans impacter les utilisateurs.

L'invention offre ainsi des avantages significatifs en termes de précision, de fiabilité, de reproductibilité, de temps de traitement et de réduction de coûts.

Selon un mode de réalisation énoncé en revendication 1, le procédé comprend, après l'extraction du module de chaque signal S(t) complexe de FID, une étape identification de la nature et de la teneur de l'au moins une espèce à caractériser à partir du module de chaque signal S(t) complexe de FID.

Selon ce mode de réalisation, le procédé comprend, après l'extraction du module de chaque signal S(t) complexe de FID et avant l'identification de la nature et de la teneur de l'au moins une espèce à caractériser à partir du module de chaque signal complexe de FID, une étape d'application d'une transformée de Fourier à un signal prenant en compte ledit module de FID.

Selon l'invention, la teneur relative de l'espèce de référence et de l'au moins une espèce à caractériser ainsi que leur temps relatifs de relaxation sont choisis de manière à ce que l'amplitude du signal de l'espèce de référence soit au moins deux fois supérieur à l'amplitude de celui de l'au moins une espèce à caractériser. Ainsi, l'échantillon est choisi de manière à ce que dans chaque signal S(t) complexe de FID acquis l'amplitude du signal de l'espèce de référence soit au moins deux fois supérieur à l'amplitude de celui de l'au moins une espèce à caractériser. De préférence, l'échantillon est choisi de manière à ce que dans chaque signal S(t) complexe de FID acquis l'amplitude du signal de l'espèce de référence soit au moins trois fois supérieur, voire au moins cinq fois supérieur, voire au moins dix fois supérieur à l'amplitude de celui de chacune des espèces à caractériser.

Selon un mode de réalisation énoncé en revendication 1, on effectue les étapes suivantes après l'étape d'acquisition par une ou plusieurs antennes d'un ou plusieurs signaux S(t) complexes de FID avant calcul du module :

- obtention d'un spectre S($\omega$) de FID par application d'une transformée de Fourier aux parties réelle et complexe de l'au moins un signal S(t) complexe de FID, le spectre S($\omega$) de FID obtenu comportant alors l'espèce de référence et l'espèce à caractériser et présentant deux portions (UFR, DFR) s'étendant chacune à partir de la fréquence de résonnance de l'espèce de référence ($F_{0Ref}$) et respectivement de part et d'autre de $F_{0Ref}$, la fréquence de l'espèce à caractériser étant située sur une première portion de spectre prise parmi lesdites deux portions (UFR, DFR);

- modélisation du signal de l'espèce de référence Sref(t) à partir des parties réelle et complexe de l'au moins un signal complexe S(t) de FID ;
- obtention d'un spectre Sref($\omega$) de l'espèce de référence par application d'une transformée de Fourier à la modélisation du signal de l'espèce de référence Sref(t), le spectre Sref($\omega$) de l'espèce de référence présentant alors deux portions de spectre s'étendant à partir de la fréquence de résonnance de l'espèce de référence ($F_{0Ref}$) du spectre Sref($\omega$) et s'étendant respectivement de part et d'autre de $F_{0Ref}$;
- obtention d'un spectre modifié $\tilde{S}(\omega)$ de FID, par substitution d'une seconde portion du spectre S($\omega$) de FID, ladite seconde portion étant la portion prise parmi lesdites deux portions (UFR et DFR) du spectre S($\omega$) et qui ne comporte pas l'espèce à caractériser, par la portion du spectre Sref($\omega$) prise parmi les deux portions de spectre s'étendant à partir de $F_{0Ref}$ du spectre Sref($\omega$) et qui s'étend du même côté que ladite seconde portion du spectre S($\omega$);
- application d'une transformée de Fourier inverse au spectre modifié $\tilde{S}(\omega)$ pour obtenir dans le domaine temporel un signal modifié $\tilde{s}(t)$ de FID ;
- calcul du module du signal modifié $\tilde{s}(t)$ de FID ;
- identification et/ou quantification des espèces à caractériser à partir du module du signal modifié $\tilde{s}(t)$ de FID.

On peut ensuite réaliser une étape d'identification et/ou de quantification des espèces à caractériser à partir du module du signal modifié $\tilde{s}(t)$ de FID.

L'invention permet d'obtenir un RSB amélioré. La prise en compte du module permet en effet de corriger automatiquement les décalages en phase et en fréquence dus notamment aux mouvements de l'échantillon durant la durée de la FID, aux inhomogénéités du champ B0 et aux inévitables variations de comportement des différentes antennes dans le cadre d'une acquisition par plusieurs antennes. Le signal de l'espèce de référence fait office de porteuse pour les signaux des espèces à caractériser et l'information de phase de ces derniers est conservée malgré la prise en compte du module.

Ainsi, le spectre obtenu permet d'identifier et de caractériser très aisément les espèces de l'échantillon.

Par ailleurs, le remplacement d'une portion du spectre S($\omega$) par une portion du spectre Sref($\omega$) issu d'une modélisation de l'espèce de référence, permet d'obtenir le spectre modifié $\tilde{S}(\omega)$ qui ne présente pas de bruit sur sa portion ne comportant pas l'espèce à caractériser. Le signal $\tilde{s}(t)$ à partir duquel est calculé le module ne comporte alors que le bruit issu de la portion de spectre S($\omega$) comportant les espèces à caractériser. Les étapes qui précèdent précédentes le calcul du module du signal modifié $\tilde{s}(t)$ de FID permettent donc d'éviter que lors de la prise en compte du module, il se produise une superposition des bruits portés initialement par les deux portions du spectre S($\omega$). Le RSB du signal obtenu est donc considérablement amélioré, puisque les inconvénients inhérents à la prise en compte du module se trouvent limités voire supprimés par ces étapes.

En outre par rapport aux solutions connues l'invention permet grâce au module de se passer d'étapes supplémentaires spécialement dédiées aux corrections de phase et de fréquence, ces étapes nécessitant habituellement un temps de traitement significatif, voire bien souvent l'intervention manuelle d'un opérateur.

Ce procédé est particulièrement avantageux dans le cadre d'une analyse spectroscopique/spectrométrique par résonance magnétique nucléaire (RMN) d'un échantillon. Il permet d'identifier et/ou de quantifier aisément les espèces de l'échantillon.

Selon un mode de réalisation avantageux énoncé en revendication 1, le procédé comprend : une étape de calcul (1314) du module du signal S(t) de FID et les étapes suivantes effectuées après calcul du module du signal modifié $\tilde{s}(t)$ de FID et avant l'étape d'identification et/ou de quantification des espèces à caractériser :

- soit : soustraction du module du signal S(t) au module du signal modifié $\tilde{s}(t)$ de FID puis soustraction du résultat obtenu à l'étape précédente au module du signal modifié $\tilde{s}(t)$ de FID ;
- soit : application d'une transformée de Fourier au module du signal S(t) et au module du signal modifié $\tilde{s}(t)$ de FID ; soustraction du spectre du module du signal S(t) au spectre du module du signal modifié $\tilde{s}(t)$ de FID ; puis soustraction du résultat obtenu à l'étape précédente au spectre du module du signal modifié $\tilde{s}(t)$ de FID.

Ainsi, la première soustraction revient à isoler les bandes latérales également désignées « sidebands » qui sont présentes dans le signal modifié $\tilde{s}(t)$ à l'issue de l'étape de « calcul du module du signal modifié $\tilde{s}(t)$ de FID » alors qu'elles ont été préalablement supprimées par la prise en compte du module du signal s(t). La deuxième soustraction permet quant à elle d'éliminer les sidebands du signal modifié $\tilde{s}(t)$ de FID. L'invention permet ainsi de supprimer de manière efficace les sidebands et plus généralement tous les artefacts antisymétriques, c'est-à-dire les artefacts dont les fréquences sont réparties de manière symétrique par rapport à la fréquence de résonance du signal de référence, dont les amplitudes sont égales et présentant des signes opposés.

Selon un mode de réalisation, au cours de l'étape d'acquisition on acquiert des signaux complexes S(t) de FID provenant de plusieurs voxels de l'échantillon, et après le calcul du module du signal modifié $\tilde{s}(t)$ de FID pour chacun des voxels on effectue une étape de filtrage spatial.

Le filtrage spatial est applicable dès lors que l'on travaille sur des CSI, qu'elles soient acquises par une ou plusieurs bobines.

Typiquement, le filtrage spatial comprend les étapes suivantes dans le cas d'une CSI à deux dimensions spatiales: multiplier chaque ligne et chaque colonne de la matrice de CSI, par une fonction « en cloche » (par exemple gaussienne, cosinus, hanning, hamming, ...) avant transformation de Fourier dans le domaine spatial. C'est pourquoi l'orque l'on souhaite réaliser le filtrage spatial après le calcul du module, on réalise la transformée de Fourier inverse dans le domaine spatial afin de revenir dans l'espace des k.

Cela représente un avantage important dans le cadre d'une CSI notamment. En effet, si le filtrage spatial est effectué après le traitement du module, les spectres des voxels de la CSI sont alignés en phase et en fréquence. Au contraire, si le filtrage spatial est effectué avant l'extraction du module, les voxels impliqués ne sont pas alignés en phase et en fréquence et la résolution du spectre résultant peut en être dégradée conduisant à une diminution du RSB. On rappelle qu'une analyse CSI implique le traitement d'une pluralité de voxels et peut par exemple résulter en une pluralité de spectres correspondant chacun à un voxel ou en une image en deux dimensions par exemple.

Selon un autre mode de réalisation, l'invention porte sur un système de spectroscopie selon la revendication 13.

Dans la présente invention, le terme antenne désigne tout type de récepteur d'ondes électromagnétiques.

BRÈVE DESCRIPTION DES FIGURES

Les buts, objets, ainsi que les caractéristiques et avantages de l'invention ressortiront mieux de la description détaillée d'un mode de réalisation de cette dernière qui est illustré par les dessins d'accompagnement suivants dans lesquels :

La FIGURE 1 décrit brièvement le type de signaux FID détectés par toute antenne des équipements RMN connus.

La FIGURE 2 compare, à partir du cas d'une seule antenne et d'une seule acquisition d'un signal FID, la méthode de l'invention et le traitement conventionnel du signal FID. La FIGURE 3 illustre le cas où l'on procède à plusieurs acquisitions successives pour obtenir un signal FID ayant un RSB suffisant pour pouvoir être exploité.

La FIGURE 4 compare des résultats expérimentaux qui illustrent l'avantage d'utiliser le module pour le traitement des signaux FID.

La FIGURE 5 illustre le cas où l'on procède à l'acquisition d'une image spectroscopique d'un volume de tissus incluant plusieurs voxels.

La FIGURE 6 compare des résultats expérimentaux obtenus pour deux voxels situés à des positions différentes dans un cerveau humain.

La FIGURE 7 illustre le cas où l'on procède à l'acquisition des signaux FID à partir d'un réseau d'antennes.

La FIGURE 8 illustre les étapes du procédé de l'invention pour le traitement des signaux FID capturés à partir d'un réseau d'antennes et les compare à celles de leur traitement conventionnel.

La FIGURE 9 compare des résultats expérimentaux obtenus à partir d'un réseau d'antennes.

Les FIGURES 10a et 10b décrivent le repliement d'artéfacts résultant de l'utilisation du module pour le traitement de signaux RMN.

Les FIGURES 11a à 11c décrivent un procédé selon un mode de réalisation de l'invention, procédé dit DFRR, où l'on remplace une moitié du spectre par un modèle de l'espèce de référence (l'eau).

Les FIGURES 12a à 12f décrivent le traitement, selon un mode particulier de réalisation de l'invention, des artéfacts antisymétriques ou « sidebands ».

La FIGURE 13 est un organigramme des étapes d'un mode de réalisation du procédé de correction de phase et/ou de fréquence de signaux FID selon l'invention.

La FIGURE 14 illustre les résultats de simulation de bruit obtenus avec différentes mises en oeuvre du procédé de l'invention.

La FIGURE 15 montre des spectres extraits d'un même voxel d'une acquisition CSI avec écho long sur un cerveau sans suppression de l'eau.

La FIGURE 16 montre deux spectres d'un même voxel d'une acquisition CSI avec écho court effectuée sur un cerveau avec suppression partielle de l'eau.

La FIGURE 17 illustre les différences qui peuvent être obtenues lorsqu'on utilise le traitement du module avant ou après un filtrage spatial sur une acquisition CSI avec écho court sur un fantôme.

La FIGURE 18 illustre la même chose que la figure précédente sur un cerveau.

La FIGURE 19 montre l'influence de l'application du traitement du module avant ou après le filtrage spatial sur une acquisition CSI d'un cerveau avec écho long.

Les FIGURES 20 et 21 illustrent le même effet que celui de la figure précédente sur une acquisition CSI effectuée d'une part sur un fantôme et, d'autre part, sur un patient. La FIGURE 22 est un organigramme des étapes d'un mode de réalisation du procédé selon l'invention.

La FIGURE 23 illustre la nécessite de conserver une partie au moins du signal de référence à l'acquisition pour pouvoir mettre en oeuvre de manière efficace le procédé selon l'invention.

Les dessins joints sont donnés à titre d'exemples et ne sont pas limitatifs de l'invention.

## DESCRIPTION DÉTAILLÉE DE L'INVENTION

La **figure 1** décrit brièvement le type de signaux détectés par toute antenne d'un équipement RMN. Le signal peut être observé après chaque émission d'une impulsion électromagnétique B1 utilisée pour perturber les noyaux d'hydrogène ou protons à l'équilibre dans le champ magnétique constant B0. Comme on l'a vu, la fréquence RF utilisée doit être de préférence en résonance avec la fréquence de Larmor des protons pour l'intensité du champ magnétique B0 développé par l'équipement RMN considéré et qui est d'autant plus élevée que le champ B0 est grand. Comme mentionné elle croît de 42 MHz par tesla.

Le signal RMN détecté est qualifié de FID de l'anglais « free induction decay » c'est-à-dire « décroissance libre de l'induction ». Il est représentatif du retour à l'équilibre des noyaux après que la perturbation électromagnétique à laquelle ils sont soumis a cessé. Par des moyens classiques qui ne sont pas décrits et qui ne sont pas nécessaires à la compréhension de l'invention, le signal FID capturé provient d'une entité volumique élémentaire de la zone couverte par l'antenne 101. Cette entité élémentaire est qualifiée de voxel 110. La taille physique d'un voxel dépend de la résolution volumique de l'équipement RMN utilisé.

Le signal capturé par l'antenne est classiquement traité par un récepteur électronique 120 comprenant principalement un amplificateur analogique 121 et deux convertisseurs analogique numérique (CAN) 124. De manière conventionnelle, après amplification, on procède en effet à une conversion de fréquence et à une détection en quadrature du signal analogique FID capturé par l'antenne à partir de signaux 122 déphasés de 90°. La conversion de fréquence a pour but de transposer le signal FID dans une gamme de fréquences compatible avec le fonctionnement des CAN qui suivent. Après filtrage 123 on obtient ainsi, pour chaque antenne, un signal complexe ayant une partie dite « réelle » et une partie dite « imaginaire ». Les signaux électriques analogiques ainsi obtenus, tous deux bien réels, sont alors échantillonnés chacun par un CAN 124 de façon à disposer d'un signal FID complexe sous forme numérique 130 ayant une composante « réelle » 132 et une composante « imaginaire » 131, c'est-à-dire en quadrature avec la partie réelle. Typiquement, pour chaque signal FID capturé, le nombre d'échantillons numériques dont on dispose pour chacune des voies est de l'ordre de $2^{10}$ c'est-à-dire 1024 échantillons. Le signal numérique 130 est ainsi susceptible d'être traité à l'aide de tous les moyens logiciels et matériels qui ont été développés depuis des décennies pour le traitement numérique des signaux analogiques. Ces moyens comprennent notamment des processeurs numériques spécialisés dits « processeurs de signaux » et d'algorithmes spécifiques notamment ceux pour mettre en oeuvre les transformées de Fourier qui permettent de faire une analyse spectrale des signaux temporels reçus.

Les diagrammes 140 et 150 représentent, sous forme analogique, les deux composantes d'un exemple de signal FID. Il s'agit, respectivement, de la partie réelle et de la partie imaginaire d'un signal FID capturé par l'antenne après amplification, conversion et détection en quadrature du signal.

En première approximation, le signal FID est une simple exponentielle décroissante. En réalité, comme il peut être perturbé par de nombreuses sources extérieures, le fait d'introduire une amplitude qui dépend du temps permet de ne faire aucune supposition sur la forme du signal FID. D'un point de vue calcul mathématique chaque signal d'antenne est ainsi une expression complexe qui est fonction du temps (t) de la forme : $A(t) = A_0(t)e^{j(\omega t+\varphi)}$ ou $\omega$ représente la fréquence de résonance de l'eau et $\varphi$ la distorsion de phase.

L'exemple de la figure 1 représente le cas simple d'une acquisition unique du signal FID à partir d'une seule antenne. On suppose en effet dans cet exemple simple que le signal capturé est d'amplitude suffisante pour être traité après une seule acquisition et qu'il n'est pas nécessaire de procéder à plusieurs acquisitions successives pour améliorer le RSB comme on le verra dans certains des cas décrits ci-après.

On pourra noter que si le patient bouge pendant l'acquisition d'une FID alors on a une modification de la fréquence et de la phase entre le début de la FID et la fin de la FID ce qui peut entrainer une modification de la forme des raies après transformée de Fourier et pourrait diminuer la précision des résultats obtenus avec le procédé selon l'invention. Ceci est en pratique peu probable car le temps d'acquisition d'une FID est de quelques millisecondes. Par contre si le patient bouge entre le moment où l'on a réglé la fréquence est le moment où l'on commence l'acquisition de la FID (de 1 à plusieurs secondes), on se retrouve dans le cas décrit par la suite.

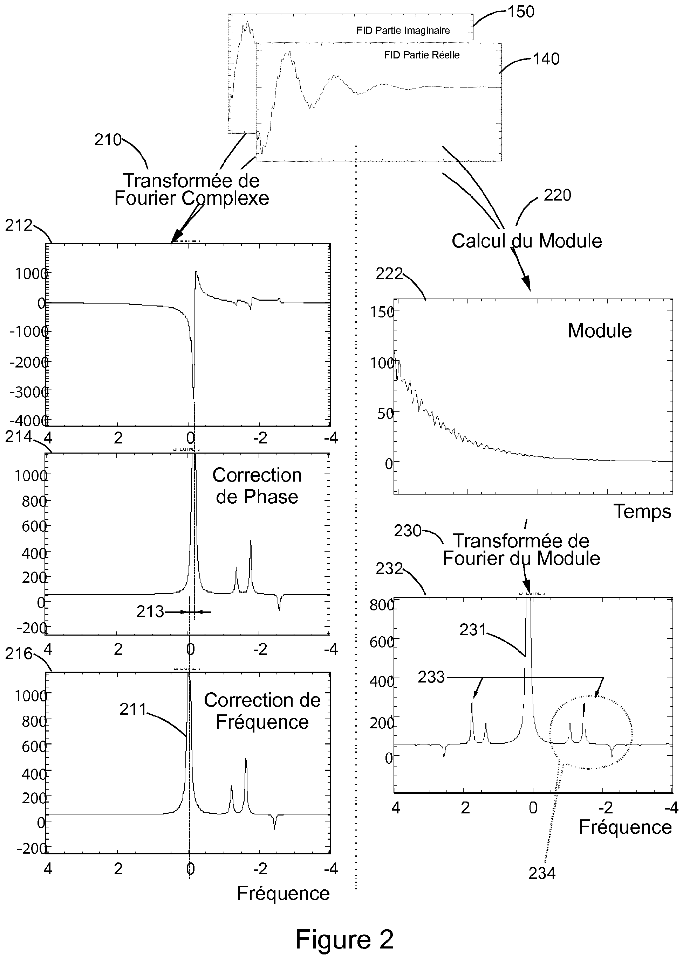

On remarquera aussi que le signal de l'eau est normalement « en résonance » c'est-à-dire que l'on règle la fréquence de conversion du récepteur exactement sur la fréquence de résonance du signal de l'eau. Lorsque ce réglage est exact, le signal de l'eau apparait effectivement comme une exponentielle décroissante. Lorsque ce réglage n'est pas exact, la fréquence du signal de l'eau est légèrement différente de la fréquence de conversion. Cela se traduit par une oscillation du signal FID. L'exponentielle décroissante est alors modulée par un sinus dont la fréquence est égale à la différence entre la fréquence du signal de l'eau et la fréquence de conversion du récepteur. L'oscillation du signal FID de la figure 1 traduit ce décalage en fréquence. Un signal acquis exactement « en résonance » serait semblable à celui du diagramme 222 de la figure 2. En ce qui concerne la phase du signal, elle est arbitraire car la phase du signal FID reçu est complètement indépendante de la phase du signal de conversion du récepteur. La conversion en fréquence au niveau du récepteur se fait en soustrayant du signal FID un signal de fréquence égale à la fréquence de Larmor. Mais le récepteur ne connait pas la phase du signal de FID. Il y a donc forcément un décalage aléatoire entre la phase du signal utilisé par le récepteur et la phase du signal de l'eau. Cela se traduit sur la figure par le fait que le premier point de la FID n'est en général pas réel. Les coordonnées de ce premier point dans le plan complexe sont dans cet exemple, si l'on se reporte aux diagrammes 140 et 150, approximativement (-60,-100). Si le signal était bien en phase les coordonnées de ce point serait (116,0) c'est à dire 116 pour la partie réelle, et 0 pour la partie imaginaire.

La **figure 2** compare, à partir du cas de la figure 1, c'est-à-dire celui d'une seule antenne et d'une seule acquisition du signal, la méthode de l'invention et le traitement conventionnel du signal FID.

Comme on l'a vu dans la figure précédente on dispose pour le signal capturé par une antenne d'une partie réelle 140 et d'une partie imaginaire 150. Le traitement conventionnel du signal FID est donc effectué dans le plan complexe. La transformée de Fourier correspondante 210, qui permet de passer du domaine temporel au domaine fréquentiel et d'obtenir une analyse spectrale du signal reçu, reflète les glissements de fréquence 213 et de phase possiblement présents dans le signal complexe 130 obtenant ainsi le spectre fréquentiel 212 auquel il faut appliquer successivement une correction de phase 214 et de fréquence 216 pour retrouver le signal de l'eau 211 en résonance, c'est-à-dire calé sur la fréquence 0 de la transformée de Fourier

Comme mentionné dans la description de la figure 1, le signal complexe de RMN est obtenu en déphasant de 90° une partie du signal reçu. Cependant, le signal recueilli est bien réel, et une fois que toutes les opérations ont été menées dans le plan complexe, pour plus de facilité mathématique, on s'arrange pour que le spectre obtenu soit lui aussi réel. À cette fin, la partie imaginaire introduite pour des raisons de facilité de calcul est alors retirée. Si l'on suppose que le signal FID est une exponentielle décroissante on obtient alors des raies étroites dites « Lorentziennes » telles que celles représentées dans le diagramme 214. Les raies du diagramme 212 sont un mélange de lorentziennes et de raies en dispersion. L'opération de mise en phase ou phasage consiste à récupérer les lorentziennes dans la partie réelle et à mettre les raies en dispersion dans la partie imaginaire. Une fois cette opération réalisée, la partie imaginaire peut être mise de côté et on ne continue à travailler que sur la partie réelle.

Le glissement de fréquence est le même que celui précédemment décrit en figure 1. Dans la figure 1 il se traduit par une modulation du signal FID alors que dans la figure 2 c'est sa représentation spectrale qui apparaît. Le glissement en fréquence est dans ce cas, comme on l'a vu, dû à la différence entre la fréquence de démodulation utilisée par le récepteur et la fréquence effective du signal de l'eau.

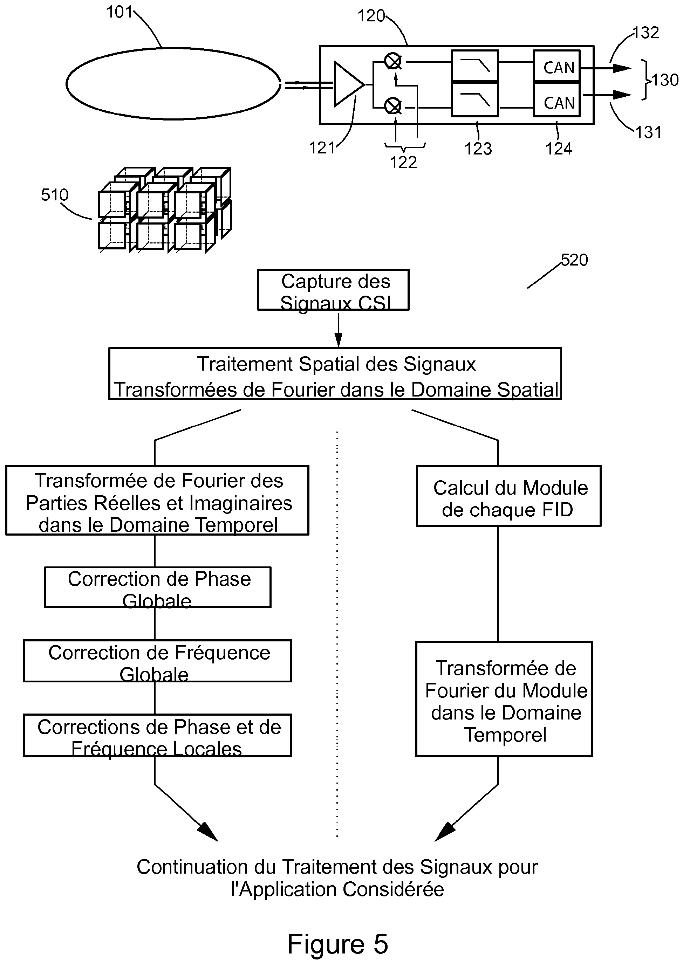

On remarquera ici qu'il faut pouvoir différencier ce qui est phase et fréquence dites « globales », telles que décrites ci-dessus, des phase et fréquence dites « relatives » qui correspondent à une différence de phase ou de fréquence par rapport à un autre signal FID, ou à une autre localisation. Si on acquiert successivement deux signaux FID, ils auront tous deux la même phase et la même fréquence globale puisque le signal de démodulation du récepteur n'a pas changé d'un signal FID à l'autre. Par contre si le patient a bougé pendant l'acquisition, la phase et la fréquence du second signal FID seront légèrement différentes du premier. C'est le cas également pour des signaux FID provenant de voxels différents comme dans le cas d'une analyse dite CSI décrite en figure 5 (une analyse CSI, acronyme de l'anglais « chemical shift imaging » signifie « imagerie de déplacement chimique » de la fréquence de résonance des noyaux comme déjà discuté brièvement plus haut). La phase et la fréquence provenant de voxels différents seront légèrement différentes en raison des variations de champ B0, mais fréquence et phase « globales » seront les mêmes pour tous les voxels.

Il y a donc en fait deux corrections à faire : une générale qui consiste à corriger les variations de phase et de fréquence générées par le convertisseur, puis FID par FID ou voxel par voxel, on pratique une correction des petites variations induites par le mouvement du patient ou les variations de champ B0.

L'invention permet de réaliser ces deux opérations en une seule fois.

Le traitement selon l'invention du signal capturé par l'antenne commence par le calcul du module 220 du signal complexe 130 tel que défini ci-dessus.

Dans l'expression complexe mentionné ci-dessus et qui est fonction du temps $(t)$ $A(t) = A_0(t)e^{j(\omega t + \varphi)}$, le terme $A_0(t)$ est le module ou amplitude du signal complexe. Ce module est indépendant de la fréquence et de la phase. D'un point de vue pratique, le module à chaque instant t est donc la racine carrée de la somme des carrés des parties réelle et imaginaire du signal FID à cet instant t tel que capturé et converti par le module électronique 120 associé à chaque antenne.

Ainsi, à chaque instant t, le module du signal FID est défini par Module de FID(t) = | A(t) | = $(A_0(t)^2 \cdot [\cos(\omega t + \varphi)^2 + \sin(\omega t + \varphi)^2])^{1/2}$ Le terme $[\cos(\omega t + \varphi)^2 + \sin(\omega t + \varphi)^2]$ étant égal à 1, on obtient le module du signal FID(t) = $A_0(t)$. S'étant affranchi des termes de phase et de fréquence parasites, on peut maintenant se consacrer à la quantification de $A_0(t)$ ce qui est en réalité le but de l'expérience.

Le signal obtenu correspond donc à chaque instant au module de la FID. Il est qualifié dans la présente de demande de brevet de « module de FID » ou plus simplement de module.

Un exemple de ce type de signal est illustré par le diagramme 222.

On applique ensuite sur le module de FID 222 la transformée de Fourier 230 afin d'obtenir son spectre fréquentiel 232. Le module du signal capturé par l'antenne ne portant aucune information de fréquence ni de phase ne nécessite donc pas qu'on y applique les corrections 214 et 216 du mode de traitement conventionnel brièvement décrit ci-dessus.

En particulier le spectre de l'eau 231 est alors toujours bien centré sur la fréquence 0. Le spectre du module, qui est un signal ayant une partie réelle uniquement, est caractérisé par le fait qu'il est symétrique 233. Il est directement exploitable par les processus suivants qui sont particuliers à chaque application RMN. L'invention permet ainsi de se passer d'étapes dédiées aux corrections de phase et de fréquence, ces étapes nécessitant habituellement un temps de traitement significatif, voire bien souvent l'intervention manuelle d'un opérateur. Selon l'invention, on choisira un échantillon qui ne présente pas, avec une solution classique basée sur une transformée de Fourier dans le domaine temporel, de signal de part et d'autre de la fréquence correspondant à celle de l'espèce majoritaire.

Le spectre du module étant symétrique on n'en retient en général qu'une des moitiés. On remarquera aussi que la transformée de Fourier du module de la FID est plus simple notamment parce que la quantité de données à traiter est moitié de celles qu'il faut traiter de façon conventionnelle où l'on opère simultanément sur les parties réelles et sur les parties imaginaires des signaux FID capturés. Le temps de traitement est donc considérablement réduit ce qui permet d'effectuer un traitement en temps réel sans impacter les utilisateurs. En particulier, on notera que le fait de ne travailler que sur un signal réel divise par deux l'occupation de la mémoire vive de l'ordinateur. Ceci permet de travailler sur un plus gros volume de donnée sans risquer un ralentissement de la machine. De plus, le fait de n'avoir à garder que la moitié du spectre après traitement divise par quatre le volume total de données à sauvegarder. Le gain en temps de calcul n'est effectivement obtenu que si la taille des données est supérieure à la taille de la mémoire allouée par l'ordinateur. Ceci est cependant souvent le cas notamment pour les analyses dites CSI, plus particulièrement décrites en figure 5, qui se font en haute résolution et mettent en jeu des tailles de données pouvant atteindre quatre gigaoctets, c'est-à-dire $4 \times 10^9$ octets.

De manière surprenante, bien qu'une partie des informations captées par les antennes (l'information de phase) soit éliminée lors de la prise en compte du module de la FID, le RSB demeure parfaitement satisfaisant.

On notera ici que l'invention s'adresse plus particulièrement aux applications RMN qui s'intéressent à l'analyse des pics secondaires 234 qui apparaissent dans la décomposition spectrale et qui sont engendrés par des métabolites possiblement présents dans les tissus examinés. L'eau constituant la majeure partie des tissus génère un signal de très forte amplitude 231 qui agit comme une porteuse et comme une référence pour les pics secondaires 234 que l'on désire détecter et qui sont caractéristiques dans le voxel examiné de la présence de métabolites. Ceux-ci créent un « chemical shift », terme utilisé dans la littérature technique en anglais sur ces sujets pour qualifier un « glissement ou décalage chimique » de la fréquence de précession des noyaux mis en résonance. Le glissement ou décalage fréquentiel apparaît dans la décomposition spectrale sous la forme de pics secondaires décalés qui révèlent la présence de ces métabolites. Le décalage en fréquence est caractéristique de la nature du métabolite. La surface du pic, relativement à celle de l'eau, permet de quantifier leur concentration dans le tissu examiné.

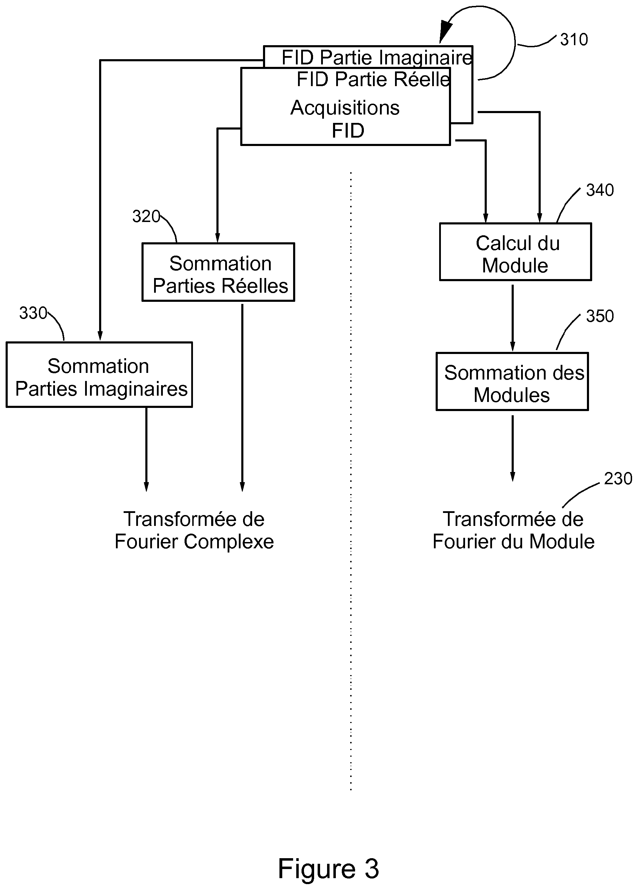

La **figure 3** illustre le cas où il faut procéder à plusieurs acquisitions 310 successives pour obtenir un signal FID ayant un RSB suffisant pour pouvoir être exploité par l'application.

Les traitements conventionnel et selon l'invention du signal FID sont pour l'essentiel identiques à ce qui est décrit dans la figure 2. Les seules différences concernent les étapes de sommation. Dans le traitement conventionnel on doit sommer séparément les parties réelles 320 et imaginaires 330 des signaux FID successifs capturés Au contraire, dans le traitement selon l'invention on procède d'abord au calcul du module 340 de chaque signal de FID. Seuls les modules de FID ont alors besoin d'être sommés 350 avant d'appliquer la transformée de Fourier 230 sur le module résultant, ce qui simplifie sensiblement le processus de calcul dans le cas de l'invention. La sommation est dans ce cas réalisée sur des signaux phasés et alignés les uns par rapport aux autres, contrairement au cas conventionnel. Ceci permet d'obtenir un RSB optimum.

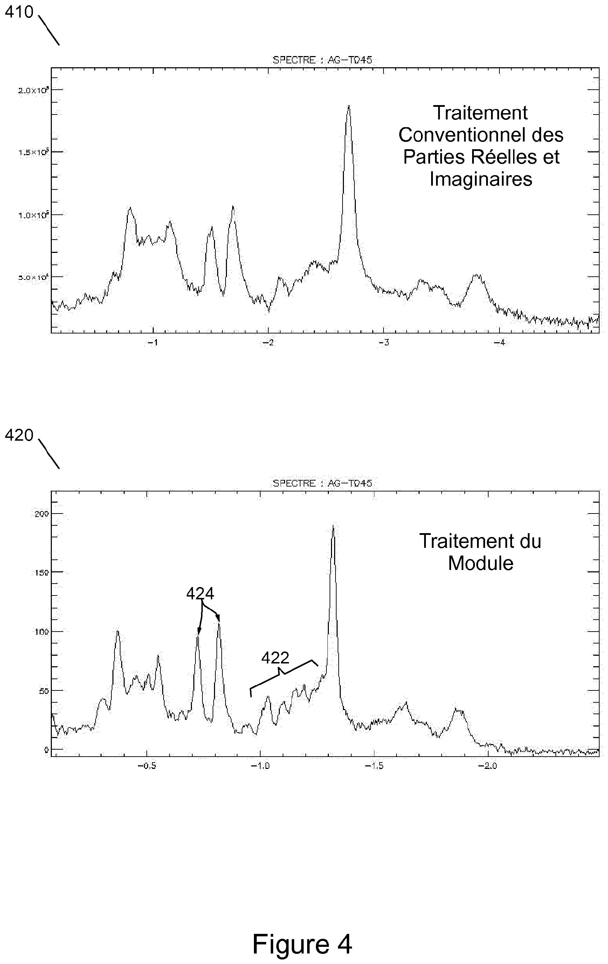

La **figure 4** compare des résultats expérimentaux qui illustrent l'avantage d'utiliser le module 420 pour le traitement des signaux FID au lieu d'utiliser le traitement conventionnel séparé des parties réelles et imaginaires 410.

Les figures 410 et 420 mettent l'accent sur la partie intéressante de chacun des spectres c'est-à-dire qu'elles ne montrent que les parties concernant les métabolites. Le signal de l'eau et le signal symétrique du volume ont été éliminés afin de rendre plus visible la région 422 du spectre.

Le diagramme 420 montre que le traitement du module améliore sensiblement le RSB du signal FID capturé et permet de diminuer la largeur des raies du spectre. Notamment, comme le montre cet exemple, la diminution de la largeur des raies révèle quelques petites résonances secondaires 422 qui n'étaient pas visibles dans le spectre conventionnel. L'invention permet ainsi de détecter des espèces difficilement détectables voire non détectables avec les solutions de l'art antérieur. La forme des résonances est également améliorée 424.

On sait que la correction de phase et de décalage ou glissement en fréquence de chaque FID, illustrée dans la figure 2, avant sommation, améliorerait la largeur des raies du spectre et le RSB. Cette correction n'est cependant en pratique jamais effectuée en raison de la difficulté qu'il y aurait à trouver la phase et la fréquence de chaque FID en temps réel avant sommation. Utiliser le module des signaux FID comme dans l'invention est donc une manière rapide, simple et robuste pour corriger l'effet des mouvements de la cible qui sont principalement à l'origine des glissements de phase et de fréquence observés lors de l'acquisition des signaux FID.

La **figure 5** illustre le cas où l'on procède à l'acquisition d'une image spectroscopique d'un volume de tissus incluant plusieurs voxels. Ce type d'analyse par CSI se pratique de façon classique en surimposant des gradients de magnétisation à la magnétisation fixe B0 de façon à pouvoir pratiquer une discrimination spatiale des signaux en provenance de chacun des voxels. Ce cas est similaire à celui de la figure 1 mais s'adresse à un volume de voxels 510 pour lesquels on peut constater entre eux des décalages de phase et de fréquence dus aux inhomogénéités du champ magnétique B0.

On remarquera ici que tout ce qui est fait dans le domaine spatial est strictement identique à ce qui se fait de manière conventionnel en imagerie RMN. De la même façon que l'on réalise une transformation de Fourier pour passer d'un signal FID à son spectre, on réalise une transformation de Fourier pour passer des signaux codés par les gradients de champ magnétique aux signaux spatialement résolus. La transformation de Fourier qui convertit le signal FID en un spectre travaille sur un signal temporel et le transforme en fréquentiel d'où le nom de TF temporelle (ou fréquentielle). La transformation de Fourier qui fait passer des signaux codés par les gradients en une image RMN travaille dans la dimension spatiale. Ce traitement est spécifique à une analyse CSI et est effectué en amont, avant même que l'invention ne soit appliquée. La figure 5 montre que la technique de l'invention est compatible avec celle des analyses CSI.

Comme on l'a vu précédemment les corrections globales sont celles qui concernent tous les signaux FID de manière identique. Il s'agit principalement des décalages en fréquence et en phase entre le signal de démodulation du récepteur et le signal effectivement acquis. Les corrections locales ou relatives sont celles qui concernent les différences de phase et de fréquence observées entre deux signaux FID acquis, soit à partir de deux bobines différentes, soit successivement par une même bobine ou soit encore si les signaux FID proviennent de régions spatialement différentes. Les différences observées sont, suivant les cas, provoquées par : un mouvement du patient, l'électronique des bobines, les variations spatiales de champs B0 ou une combinaison de ces phénomènes.

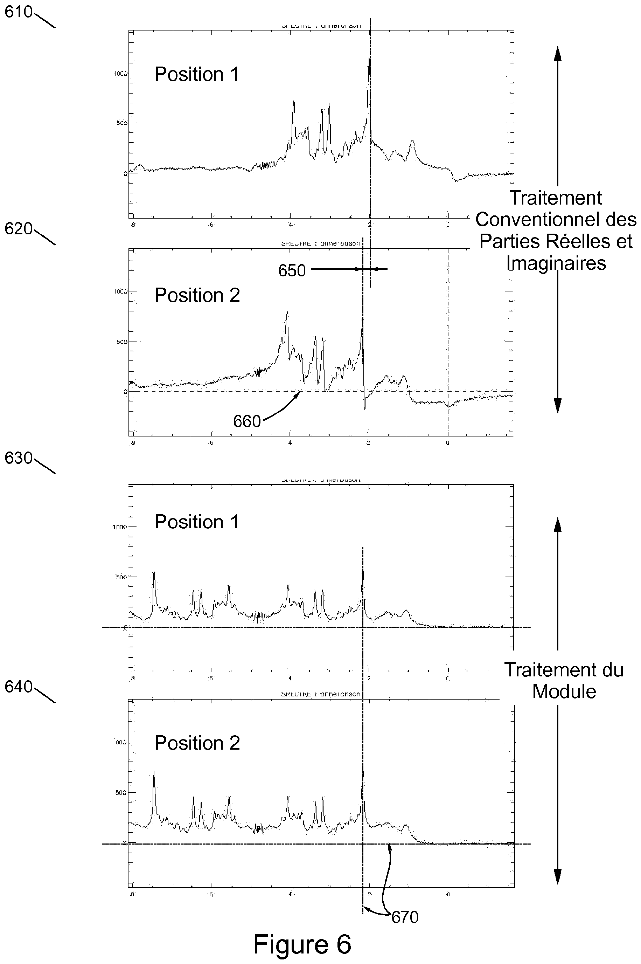

La **figure 6** compare des résultats expérimentaux obtenus dans les conditions décrites dans la figure précédente pour deux voxels situés à des positions différentes dans un cerveau humain.

Les diagrammes 610 et 620 d'une part et 630 et 640 d'autre part décrivent, respectivement, les signaux obtenus pour deux voxels à des positions différentes (1 et 2) avec un traitement conventionnel des signaux FID capturés et un traitement selon l'invention de leurs modules.

On remarque que les décalages de fréquence 650 et de phase 660 qui apparaissent dans le traitement conventionnel des signaux capturés n'apparaissent plus 670 dans le traitement du module ce qui améliore très sensiblement leur quantification.

On notera ici que dans le cas décrit dans les figures 5 et 6 ci-dessus, c'est-à-dire pour l'acquisition de signaux CSI, on pourra avoir aussi à procéder à des acquisitions multiples pour améliorer le RSB. L'invention s'appliquera également comme décrit précédemment et en particulier comme décrit dans la figure 3 avec sommation des modules des FID.

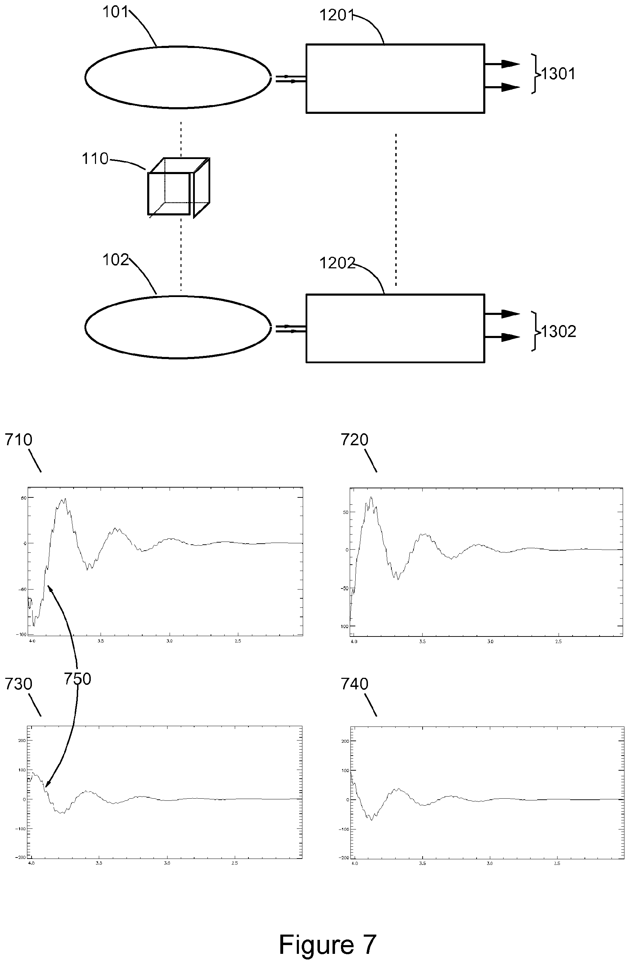

La **figure 7** illustre le cas où l'on procède à l'acquisition des signaux FID à partir d'un réseau d'antennes comme discuté dans le chapitre sur l'état de la technique. L'invention est particulièrement avantageuse pour ce cas complexe où il faut aussi pouvoir corriger facilement les différences importantes, notamment de phase, qui peuvent exister entre les antennes individuelles.

Dans ce cas, le signal FID émis par chaque voxel 110 est capturé par plusieurs antennes. Deux antennes, 101 et 102, sont représentées dans cet exemple. Il est courant d'en associer un plus grand nombre, par exemple des réseaux de huit antennes sont fréquemment utilisés. Chaque antenne individuelle est munie de son propre système de réception, 1201 et 1202 dans cet exemple, délivrant chacun un signal FID complexe, 1301 et 1302.

Les diagrammes 710 et 730 d'une part et 720 et 740 d'autre part sont, respectivement, des exemples des parties réelles et des parties imaginaires des signaux FID complexes délivrés par chacune des antennes. Comme attendu, on peut constater de fortes différences 750 dans la phase et l'amplitude des signaux capturés par les antennes individuelles du réseau d'antennes.

On notera ici qu'il existe un décalage global de phase et de fréquence qui est commun à toutes les antennes individuelles du réseau cependant les différences individuelles de phase et d'amplitude entre antennes doivent toujours être compensées comme on va le voir ci-après.

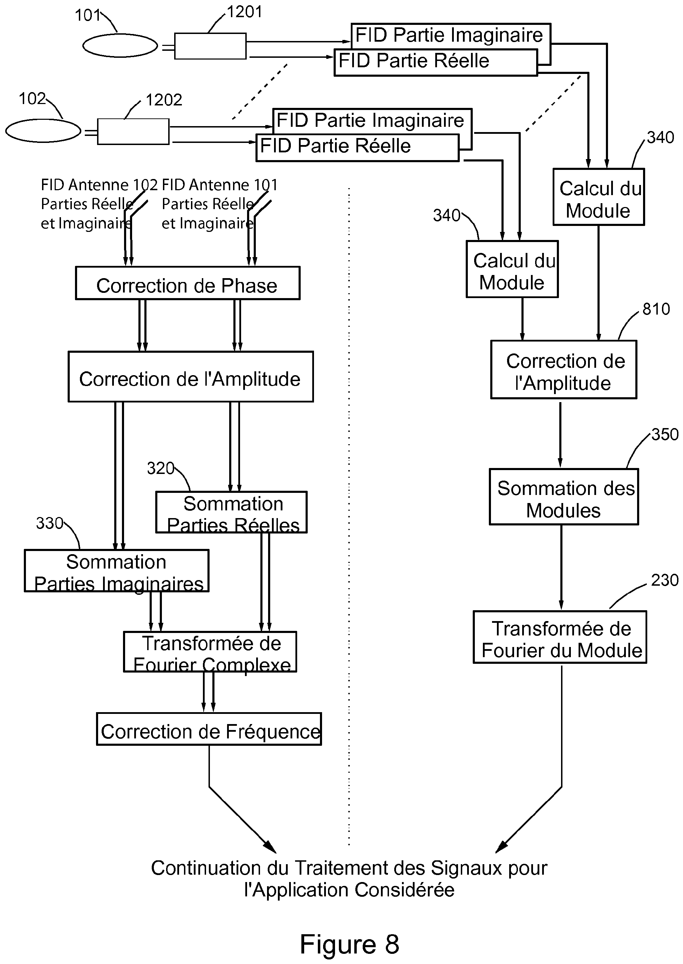

La **figure 8** illustre les étapes du procédé de l'invention pour le traitement des signaux FID capturés à partir d'un réseau d'antennes et les compare à celles de leur traitement conventionnel.

Le processus de l'invention reste extrêmement simple et n'est pas sensiblement différent de ce qui a été décrit dans la figure 3 pour l'acquisition successive de signaux FID à partir d'une seule antenne. Dans le cas de la figure 8 les signaux sont acquis, de préférence simultanément, et on procède au calcul du module 340 sur chacun des signaux acquis à partir des antennes individuelles 101 et 102 dans cet exemple. Il n'est pas exclu bien sûr de procéder aussi, comme dans la figure 3, à des acquisitions multiples dans le cas d'un réseau d'antennes.

Une différence notable dans le cas d'un réseau d'antenne est qu'il faut à l'étape suivante 810 procéder à une correction de l'amplitude des modules provenant d'antennes différentes afin de tenir compte de toutes les différences existant inévitablement entre les antennes individuelles formant le réseau.

Une méthode pour appliquer cette correction de l'amplitude consiste à effectuer une pondération de chaque signal de FID. On peut par exemple appliquer à chaque module de FID un facteur de pondération de la bobine dont il provient, ce facteur de pondération étant égal au carré du module de la FID à l'instant t=0 divisé par la somme des carrés des module des chaque FID à l'instant t=0.

On procède ensuite, comme précédemment, à la sommation 350 des modules dont l'amplitude vient d'être pondérée. On peut alors calculer la composition spectrale du module résultant de la combinaison des signaux FID à l'aide d'une transformée de Fourier 230.

Il convient de noter que la pondération des signaux de FID, bien que préférable, n'est qu'optionnelle.

Par comparaison le processus conventionnel, beaucoup plus complexe, figure sur la partie gauche de la figure 8. Cette partie est aussi à comparer avec la figure 2 qui ne concerne qu'un signal FID. On remarquera ici que dans le cas de la figure 2 la correction de phase peut être indifféremment réalisée avant ou après la transformation de Fourier puisqu'il n'y a qu'un seul signal FID. Elle est traditionnellement effectuée manuellement après la transformée de Fourier car il est plus simple de visualiser les variations de phase sur le spectre que sur le signal FID. Dans le cas de la figure 8 cette correction est réalisée avant car on recombine d'abord les signaux des différentes bobines avant d'effectuer le traitement. Toutefois, on pourrait aussi envisager de réaliser la transformée de Fourier de chaque signal de chaque bobine, puis de les phaser et de les sommer. Cependant, cela demande alors de réaliser autant de transformations de Fourier qu'il y a de bobines, par exemple 64 si l'on dispose de 64 bobines.

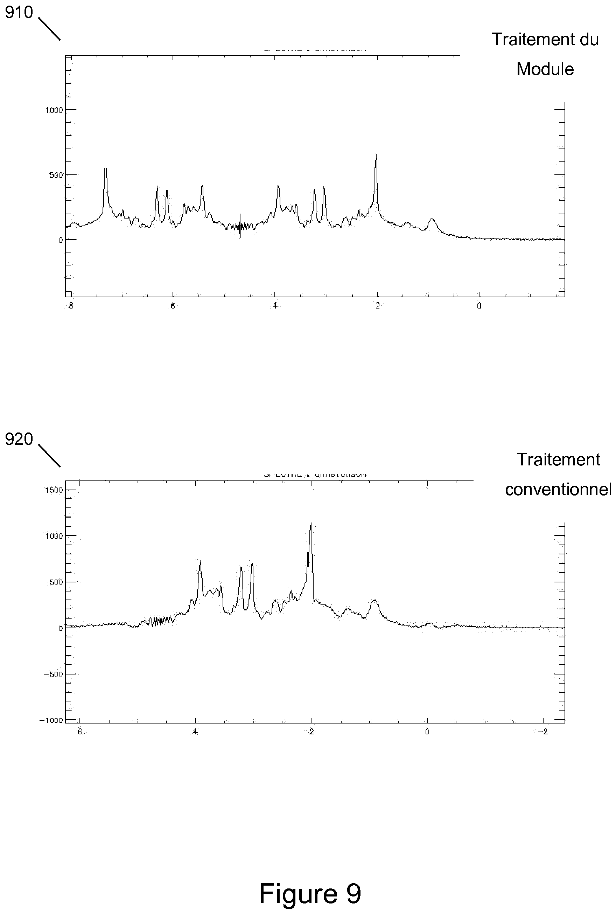

La **figure 9** compare des résultats expérimentaux obtenus à partir d'un réseau d'antennes dans les conditions décrites dans la figure précédente.

Les diagrammes 910 et 920 montrent les spectres obtenus après acquisition et sommation des signaux FID, transformation de Fourier puis suppression de la raie de l'eau dans ces exemples pour mieux visualiser les métabolites. Le diagramme 920 montre la partie réelle du spectre obtenue à l'issue du traitement conventionnel des signaux FID. Comme mentionné précédemment, la partie imaginaire est introduite artificiellement par le récepteur et ne contient aucune information supplémentaire. Elle n'est donc utilisée que lors du traitement des signaux, jamais dans la présentation des résultats. Le diagramme 910 montre le résultat du traitement selon l'invention du module des signaux FID. Comme déjà mentionné, le traitement du module conduit à une symétrisation du spectre dont on ne garde qu'une moitié. Les pics présents sur le diagramme 920 obtenu avec les systèmes connus se retrouvent bien dans le diagramme 910 obtenu avec la solution de l'invention. Ainsi, en dépit de la perte d'information induite par la prise en compte du module avant sommation des différentes FID, les métabolites peuvent toujours être caractérisés. Caractériser une espèce consiste généralement à identifier la nature de cette espèce dans l'échantillon et/ou à la quantifier. On remarque en outre que ses pics sont très étroits, ce qui permet une caractérisation précise et montre que le rapport signal/bruit n'est pas dégradé de manière visible par le traitement selon l'invention du module du signal.

Comme le montre la figure 9 il peut être avantageux de supprimer l'eau pour améliorer l'acquisition des signaux provenant des métabolites. En effet, dans le cerveau, le signal de l'eau est très supérieur à celui des métabolites, de l'ordre de $10^5$ fois. Afin de bénéficier de toute la dynamique des convertisseurs analogique numérique (CAN) le signal de l'eau est souvent supprimé partiellement ou complètement avant acquisition du signal FID.

Dans les méthodes connues et comme dans le cas du résultat de la figure 920 qui illustre un traitement conventionnel, le signal de l'eau est typiquement supprimé en deux étapes. Une première étape est effectuée lors de l'acquisition en utilisant une séquence appropriée (il s'agira d'une atténuation dans ce cas). Comme cette suppression n'est jamais parfaite, une seconde suppression est réalisée après sommation pour diminuer le nombre de signaux à traiter, en général juste avant la quantification des spectres. Comme mentionné ci-dessus la première suppression a pour but de diminuer l'amplitude du signal reçu par le convertisseur analogique numérique du récepteur, et donc de garder la pleine plage de codage, qui est typiquement de 16 bits, pour numériser au mieux les signaux les plus petits. La seconde étape est réalisée pour faciliter la quantification des métabolites. Pour cela on modélise le signal de l'eau en réalisant une décomposition en valeur singulière du signal, et en ne retenant dans les composantes principales que celles qui correspondent au signal de l'eau. On reconstruit un signal à partir de ces valeurs que l'on soustrait au spectre.

Toutefois, comme on l'a vu, le signal de l'eau est utilisé comme signal de référence de phase et de fréquence dans le cadre de l'invention. On pratique alors une suppression uniquement partielle de l'eau pour garder un signal d'amplitude suffisante pour être exploité. Comme déjà aussi mentionné précédemment le signal de l'eau peut également être utilisé comme référence de concentration pour estimer la concentration absolue des métabolites. Il est dans ce cas nécessaire d'obtenir la totalité du signal de l'eau. Souvent, pour concilier les impératifs liés à une meilleure visualisation des métabolites d'une part et à leur quantification d'autre part on peut être amené à pratiquer deux expérimentations successives, l'une avec suppression partielle ou totale de l'eau et l'autre sans.

Les aspects théoriques de l'invention sont supportés par les développements mathématiques qui suivent.

Si $A(t)$ est le signal acquis depuis un voxel fait d'un seul composé, c'est-à-dire une seule espèce, en l'absence de bruit, il s'exprime comme indiqué dans l'équation [1] ci-après :

$$A(t) = A_0(t)e^{j(\omega t + \varphi)} \qquad [1]$$

dans laquelle $A_0(t)$ est la forme d'onde du signal FID, $\omega$ la fréquence de résonance du composé unique et $\varphi$ représente toutes les distorsions de phase.

Une façon de corriger les distorsions de phase consiste à prendre le module du signal comme indiqué dans l'équation [2] ci-après :

$$\|A(t)\| = A_0(t) \qquad [2]$$

Le module enlève également l'information de fréquence et après transformation de Fourier le résultat est un signal « en résonance ». Si on suppose maintenant que le composé unique correspond au pic de l'eau, on obtient, en utilisant la même notation que dans l'équation [1], l'expression suivante :

$$H2O(t) = A_{H2O}(t)e^{j(\omega_{H2O}t + \varphi_{H2O})} \qquad [3]$$

On notera que dans ces équations l'espèce de référence est considérée comme étant l'eau. L'invention n'est cependant pas limitée à l'eau comme espèce de référence. Ainsi, ces équations seront pourront être utilisées en remplaçant l'eau par n'importe quel solvant faisant office d'espèce de référence.

En ajoutant un autre composé au signal de l'eau, le module du signal acquis devient alors :

$$\|S(t)\| = \sqrt{(H2O(t) + A(t))^* (H2O(t) + A(t))} \qquad [4]$$

Dans cette expression le caractère * indique la conjuguée complexe. En utilisant les équations [1] et [3], après développement, le produit sous la racine carrée peut être écrit comme suit :

$$\|S(t)\|^2 = \left(A_{H2O}(t)e^{-j(\omega_{H2O}t + \varphi_{H2O})} + A_0(t)e^{-j(\omega t + \varphi)}\right)\left(A_{H2O}(t)e^{j(\omega_{H2O}t + \varphi_{H2O})} + A_0(t)e^{j(\omega t + \varphi)}\right)$$

$$= A_{H2O}(t)^2 + A_0(t)^2 + A_0(t)A_{H2O}(t)\left(e^{-j(\omega_{H2O}t + \varphi_{H2O})}e^{j(\omega t + \varphi)} + e^{j(\omega_{H2O}t + \varphi_{H2O})}e^{-j(\omega t + \varphi)}\right)$$

$$= A_{H2O}(t)^2 + A_0(t)^2 + A_0(t)A_{H2O}(t)\left(e^{j((\omega - \omega_{H2O})t + \varphi - \varphi_{H2O})} + e^{-j((\omega - \omega_{H2O})t + \varphi - \varphi_{H2O})}\right)$$

$$= A_{H2O}(t)^2 + \left(A_0(t)^2\right) + 2A_0(t)A_{H2O}(t)\cos\left((\omega - \omega_{H2O})t + \varphi - \varphi_{H2O}\right)$$

Si on introduit maintenant les termes $\Delta\omega = \omega - \omega_{H2O}$ et $\Delta\varphi = \varphi - \varphi_{H2O}$ qui correspondent respectivement aux glissements de fréquence et de phase entre le composé ajouté et celui de l'eau on obtient :

$$\left\|S(t)\right\|^2 = A_{H2O}(t)^2 + \left(A_0(t)^2\right) + 2A_0(t)A_{H2O}(t)\cos\left(\Delta\omega t + \Delta\varphi\right)$$

$$= \left(A_{H2O}(t) + A_0(t)\cos\left(\Delta\omega t + \Delta\varphi\right)\right)^2 + A_0(t)^2 - \left(A_0(t)\cos\left(\Delta\omega t + \Delta\varphi\right)\right)^2$$

$$= \left(A_{H2O}(t) + A_0(t)\cos\left(\Delta\omega t + \Delta\varphi\right)\right)^2 + A_0(t)^2\left(1 - \cos^2\left(\Delta\omega t + \Delta\varphi\right)\right)$$

$$= \left(A_{H2O}(t) + A_0(t)\cos\left(\Delta\omega t + \Delta\varphi\right)\right)^2 + \left(A_0(t)\sin\left(\Delta\omega t + \Delta\varphi\right)\right)^2$$

et finalement l'équation [5]

$$\left\|S(t)\right\| = \sqrt{\left(A_{H2O}(t) + A_0(t)\cos\left(\Delta\omega t + \Delta\varphi\right)\right)^2 + \left(A_0(t)\sin\left(\Delta\omega t + \Delta\varphi\right)\right)^2}$$

$$= \left(A_{H2O}(t) + A_0(t)\cos\left(\Delta\omega t + \Delta\varphi\right)\right)\sqrt{1 + \left(\frac{A_0(t)\sin\left(\Delta\omega t + \Delta\varphi\right)}{A_{H2O}(t) + A_0(t)\cos\left(\Delta\omega t + \Delta\varphi\right)}\right)^2} \qquad [5]$$

En faisant l'hypothèse que $A_{H2O}(t)$ est très grand devant $A_2(t)$, ce qui est le cas dans toutes les expérimentations où l'on ne supprime pas l'eau, le second terme de l'expression peut être négligé. On obtient alors l'expression suivante :

$$\left\|S(t)\right\| = A_{H2O}(t) + A_0(t)\cos\left(\Delta\omega t + \Delta\varphi\right) \qquad [6]$$

La description de l'invention qui continue ci-après tient compte de ce que la technique exposée en détail dans les figures précédentes (figures 1 à 9) et qui consiste à utiliser le module des signaux FID peut, pour certaines applications, présenter des limitations.

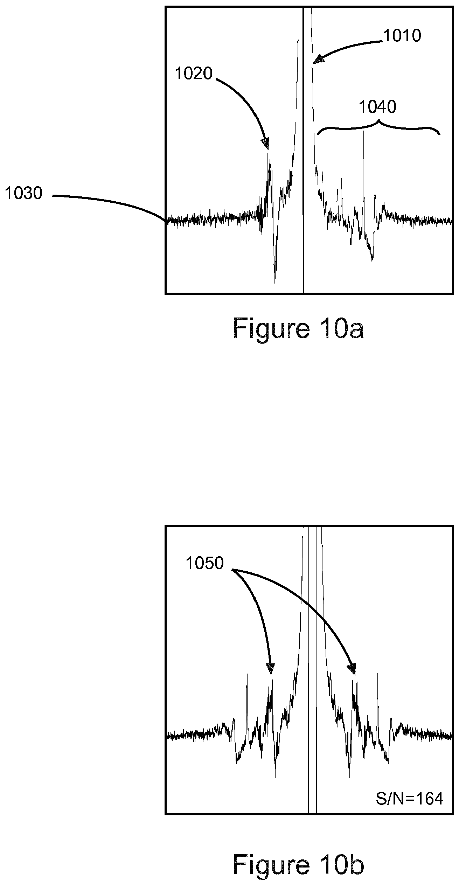

En effet, comme on l'a vu, l'utilisation du module des signaux FID entraîne une symétrisation du spectre autour de la fréquence de l'espèce de référence, le plus souvent l'eau 1010, de telle façon que, comme illustré dans les **figures 10a et 10b,** le bruit 1030 et les éventuels artefacts 1020 qui sont situés à gauche du spectre se superposent alors au signal résultant de la symétrisation comme illustré dans la figure 10b. On constate alors, non seulement une augmentation du bruit, mais aussi un repliement des artéfacts dans la partie intéressante du spectre, celle de droite 1040, dans laquelle se trouve le plus généralement les métabolites que l'on cherche à analyser.

Les artefacts peuvent être dus à plusieurs raisons. Parmi ces raisons, l'on peut citer :

- des signaux non désirés qui peuvent provenir de la région explorée, ou de régions proches de la région explorée. Ces signaux devraient être éliminés par la séquence d'acquisition, mais cette élimination peut être défaillante, à cause par exemple de mouvements du sujet, de mouvements d'objet autour de l'aimant qui peuvent modifier le champ magnétique (ouvrir et/ou fermer une porte de la pièce par exemple), d'une mauvaise homogénéité du champ magnétique, d'une variation du champ magnétique au cours du temps.
- des signaux désirés mais qui pour les même raisons que citées ci-dessus sont décalées par rapport à leur fréquence de résonance normale. Par exemple de l'eau issue d'une région où l'inhomogénéité du champ fait que sa fréquence de résonance est décalée de plusieurs Hertz par rapport à la fréquence de résonance de la région explorée (œil, liquide synovial,...) peut apparaître comme une résonance supplémentaire.
- des perturbations électromagnétiques (onde radio, wifi, ...) qui sont captées par la sonde de RMN et se superposent au spectre.
- un signal parasite. Par exemple, les séquences d'acquisition comportent de nombreuses impulsions et il peut se trouver que certaines combinaisons de ces impulsions créent un signal parasite qui vient se superposer au spectre.

Comme indiqué précédemment, quelle que soit la cause de ces artefacts, ces derniers et/ou le bruit situés à gauche du signal de l'eau se retrouvent, par la symétrisation induite par le module, superposés au signal situé à droite de l'eau.

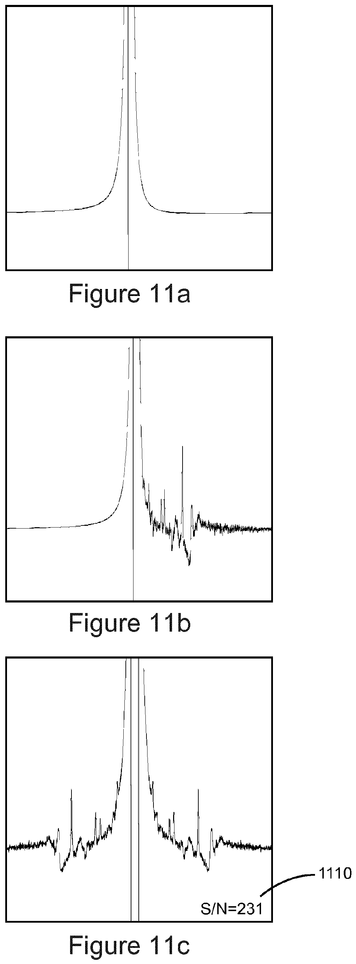

Les figures **11a à 11c** illustrent et décrivent brièvement la solution qui est apportée à ce problème par l'invention.

Comme montré sur la figure 11a on procède tout d'abord à une modélisation du spectre de l'eau à partir d'un échantillon que l'on souhaite caractériser. Cette modélisation va être utilisée dans l'invention pour remplacer la moitié du spectre acquis, située à gauche de la fréquence de l'espèce de référence, par la portion correspondante du modèle. On obtient alors le résultat illustré par la figure 11b. Le spectre ainsi recomposé ne comporte ni bruit ni artefact dans la partie gauche. La partie droite correspond au signal acquis comprenant les espèces à caractériser. Les étapes qui suivent sont identiques à celles qui ont été décrites précédemment : on effectue une transformée de Fourier inverse pour revenir à une FID dans le domaine temporel; on extrait le module du spectre recomposé ; puis on repasse dans le domaine fréquentiel, typiquement par une transformée de Fourier, de manière à obtenir un spectre final non perturbé par le bruit et les éventuels artefacts de la partie gauche comme illustré par la figure 11c.

On constate que le SNR est alors amélioré, comme attendu, d'un rapport racine carrée de 2 par rapport à la valeur correspondante de la figure 10b.

Afin de modéliser la porteuse, c'est à dire le signal de l'espèce de référence, on peut recourir à plusieurs techniques. L'une de ces techniques est largement utilisée dans ce domaine pour modéliser l'eau. Cette modélisation sert ensuite à soustraire le signal modélisé de l'eau au spectre NMR. Cette technique de modélisation est connue sous le nom de HLSVD, acronyme de l'anglais « Hankel Lanczos Singular Value Décomposition » c'est-à-dire « méthode de décomposition en valeurs singulière de Hankel Lanczos ». Appliquée à la présente invention pour modéliser le signal de l'espèce de référence, la méthode HLSVD comprend les étapes principales suivantes :
Une matrice est créée à partir du signal de FID (la première ligne de cette matrice contient le signal de FID, les lignes suivantes contiennent les permutations circulaires de ce signal de FID, de 1 point pour la 2ème ligne, 2 point pour la 3ème ligne, etc.)

Cette matrice est décomposée en valeurs propres et vecteurs propres, puis seules les 10 ou 20 composantes principales sont retenues.

Parmi ces 10 ou 20 (le choix est laissé à l'utilisateur) composantes principales, seules celles qui apparaissent à une fréquence proche de celle du signal de l'eau (par exemple 0.5 ppm autours de la position du signal de l'eau) sont retenues. Un signal de FID est alors reconstruit à partir de ces résonances. Par cette décomposition, le signal de l'eau qui peut avoir une forme arbitraire est décomposé en plusieurs lorentziennes. C'est la somme de ces lorentzienne qui reproduit la forme du signal de l'eau.

On pourra notamment se référer à la publication suivante concernant cette technique de modélisation : « SVD-Based Quantification of Magnetic Resonance Signals », dont les auteurs sont PIJNAPPEL, Van DEN BOOGAART, DE BEER, VAN ORMONDT et qui a été publiée dans « Journal of Magnetic Resonance 97, 122-134 (1992) ».

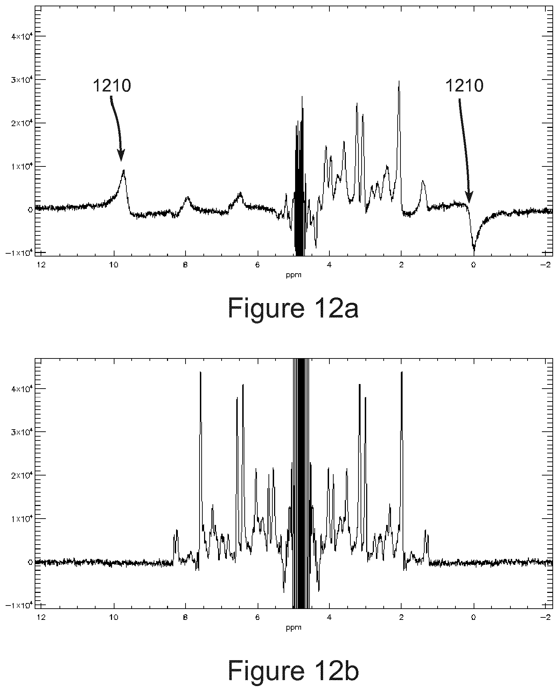

La technique décrite dans les figures 11a à 11c apporte cependant elle-même une autre limitation dans les cas où l'on constate la présence dans le spectre capturé d'artéfacts antisymétriques généralement qualifiés du terme anglais de « sidebands » puisqu'elles prennent le plus souvent la forme de pics ou de bandes latérales. Ce type d'artéfacts 1210 est illustré dans l'exemple de la **figure 12a.** Ces artefacts présentent deux à deux des fréquences symétriques par rapport à la fréquence de résonance du signal de référence, des amplitudes égales et des signes opposés. Leur traitement par la technique décrite dans les figures 1 à 9, où l'on utilise le module des signaux FID, conduit à superposer dans la partie de spectre à droite de l'eau des artefacts antisymétriques. Ce traitement conduit donc à supprimer automatiquement ce type d'artefacts indésirable et l'on obtient en effet après traitement du module des signaux un spectre, comme montré sur la **figure 12b,** où ils n'apparaissent plus.

Cet avantage est évidemment perdu quand on applique préalablement la technique brièvement décrite dans les figures 11a à 11c qui permet de réduire le bruit et d'enlever les artéfacts asymétriques 1020 du type illustré par la figure 10a.

Les figures suivantes décrivent donc une technique complète qui améliore le bruit et permet aussi d'enlever les artéfacts antisymétriques 1210 de type « sideband » et asymétriques 1020.

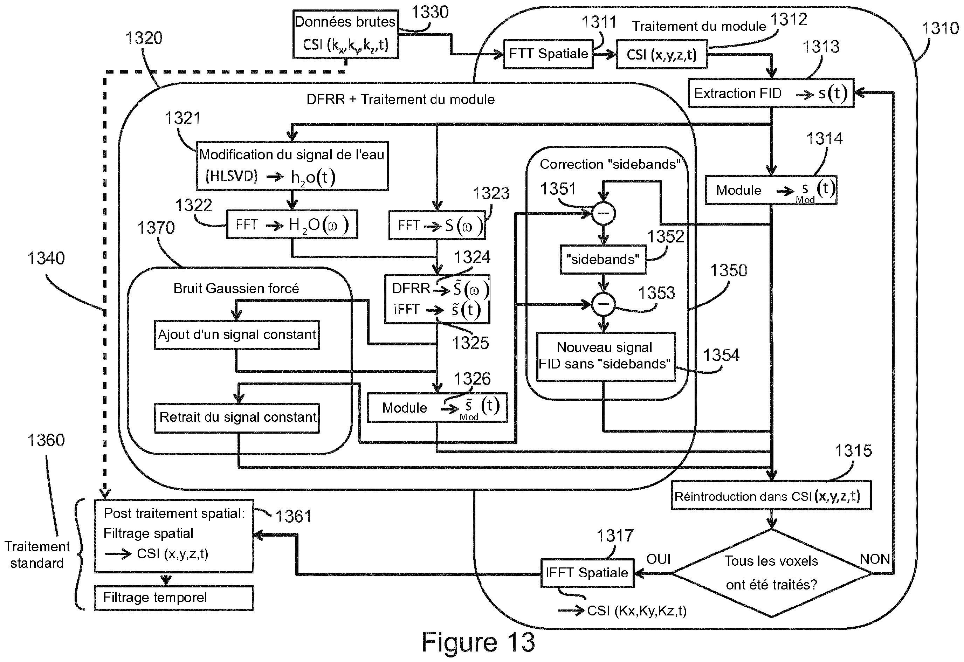

La **figure 13** montre, dans le cadre 1310, l'organigramme du traitement du module des signaux FID tel que décrit précédemment dans les figures 1 à 9 et qui s'applique plus particulièrement à un processus de type CSI dans cet exemple sans que cela soit limitatif. Les étapes qui doivent être ajoutées afin d'obtenir les résultats complémentaires mentionnés ci-dessus, c'est-à-dire : amélioration du RSB et suppression des artéfacts, sont incluses dans le cadre 1320. Le traitement supplémentaire est désigné ci-après « DFRR », acronyme de l'anglais « Downfield région replacement » en référence au remplacement d'une partie du spectre par un modèle comme brièvement déjà décrit dans les figures 11a à 11c. Ce traitement peut également être qualifié de substitution d'une partie du spectre par la partie correspondante du spectre du signal de référence. Les composants de l'organigramme ne faisant pas partie de ces deux cadres sont décrits plus loin.

À partir du flot des données brutes CSI 1330 capturées, on leur applique un traitement de type transformée de Fourier dans le domaine spatial 1311. L'algorithme utilisé est de type FFT, acronyme de l'anglais « fast Fourier transform », qui est très largement utilisé pour le traitement des signaux analogiques numérisés. La FID d'un premier voxel S(t) est extraite 1313 du fichier CSI 1312 et traitée à l'aide d'une méthode de modélisation telle que la méthode HLSVD mentionnée précédemment. Le modèle du signal de l'espèce de référence est ainsi extrait 1321 de la décomposition en valeurs singulières en sélectionnant les résonances qui sont dans une plage allant de plus ou moins 0,5 ppm (partie par million) autour de la résonance de l'eau. Le signal de l'espèce de référence est désigné par le terme générique *Sref(t).* Cette espèce de référence étant bien souvent l'eau, dans l'exemple qui suit, le terme utilisé pour le signal de l'espèce de référence sera h2o(*t*). Naturellement l'invention s'applique quelle que soit l'espèce de référence, cette dernière étant avantageusement prise parmi un solvant. Habituellement, h2o(*t*) est utilisé pour enlever le signal de l'eau résiduelle et on le retranche du signal S(t). En ce qui concerne l'invention, on calcule à la fois la FFT de S(t) et de h2o(*t*) conduisant à obtenir, respectivement, $S(\omega)$ et $H2O(\omega)$ (ce dernier terme désignant le spectre des fréquences du signal de l'espèce de référence, typiquement l'eau. Ce dernier terme est équivalent au terme *Sref(ω)* qui est également utilisé dans la présente description, ces deux termes pouvant être interchangés quel que soit le mode de réalisation, et notamment dans les modes de réalisation où l'espèce de référence n'est pas de l'eau). Ces deux étapes de calcul de FFT sont respectivement référencées 1322 et 1323 dans le cadre 1320 de la figure 13.

Si l'acquisition est effectuée avec le signal de l'espèce de référence en résonance, $S(\omega)$ peut être séparé en deux régions : la région vers les champs faibles (DFR), qui est la moitié de la partie du spectre située à la gauche du signal de l'espèce de référence; et la région vers les champs forts (UFR) qui est l'autre moitié de la partie du spectre à la droite de la résonance de l'espèce de référence. Chacune de ces deux régions s'étend depuis la fréquence de résonance $F_{0Ref}$ de l'espèce de référence.

De même, le spectre du signal de l'eau modélisé à partir de S(t) peut être séparé en deux régions : la région vers les champs faibles, qui est la moitié de la partie du spectre située à la gauche du signal de l'espèce de référence; et la région vers les champs forts qui est l'autre moitié de la partie du spectre à la droite de la résonance de l'espèce de référence. Chacune de ces deux régions s'étend depuis la fréquence de résonance $F_{0Ref'}$ de l'espèce de référence dans ce spectre issu d'une modélisation. En pratique, la fréquence de résonance du signal de l'espèce de référence $F_{0Ref'}$ du spectre modélisé est égale à la fréquence de résonance du signal de l'espèce de référence $F_{0Ref}$ du spectre comprenant toutes les espèces, soit: $F_{0Ref'} = F_{0Ref}$

Si on suppose maintenant que toutes les résonances des métabolites auxquelles on s'intéresse sont situées dans la partie UFR du spectre, la DFR ne contient que du bruit et des artefacts. Cette région peut donc être remplacée 1324 par la même région extraite du modèle du signal de l'eau $H2O(\omega)$ sans modifier la quantification du spectre.

La région à droite de l'espèce de référence dans le signal modélisé $H2O(\omega)$ de l'espèce de référence n'est donc pas soustraite au signal $S(\omega)$ comportant les espèces à caractériser, mais elle est substituée à la partie DFR du signal $S(\omega)$. Le remplacement 1324 de la DFR $S(\omega)$ par la DFR de $H2O(\omega)$ conduit à un nouveau signal de spectre $\tilde{S}(\omega)$ caractérisé par une DFR sans bruit et sans artefacts qui peut être décrit comme suit :

$$\tilde{S}(\omega) = S(\omega) \text{ if } \omega < 0$$
$$= H2O(\omega) \text{ if } \omega > 0$$

Utiliser $H2O(\omega)$ en tant que modèle pour la DFR n'introduit pas de rupture dans le nouveau signal $\tilde{S}(\omega)$ comme ce serait le cas si on avait simplement rendu nulle ou enlevée la DFR. La variable $\tilde{S}(\omega)$ est toujours continue, sa dérivée est également continue. Comme déjà mentionné on appelle cette étape 1324 du processus DFRR. Si maintenant on calcule 1325 la transformation de Fourier rapide inverse (iFFT) de $\tilde{S}(\omega)$, on obtient une nouvelle FID $\tilde{s}(t)$ dans le domaine temporel. Puis le module de $\tilde{s}(t)$ est calculé 1326 et réintroduit 1315 dans le fichier CSI original.

Ce système a été de préférence choisi parce que la technique de décalage de voxel utilisée est basée sur la manipulation de l'espace dit k (k-space) qui est une structure de données bien connue et largement utilisée en RMN. Les données sont ensuite reconstruites dans l'espace k.

Ensuite, le traitement standard 1360 peut être effectué comme cela se ferait sur les données brutes d'origine dans le cas d'un traitement conventionnel qui emprunterait le chemin direct 1340, comme le prévoit l'état de la technique.

Après l'étape de calcul du module du signal modifié $\tilde{s}(t)$ de FID et sa réintroduction 1315 dans le fichier CSI on peut, selon un mode de réalisation, se passer d'appliquer une transformée de Fourier. On réalise alors l'identification et/ou la quantification dans le domaine temporel. Dans ce cas, des logiciels bien connus permettent par exemple de sommer des FID élémentaires prédéterminées et correspondant chacune à une espèce, de manière à approximer le module du signal modifié $\tilde{s}(t)$ de FID. Les FID élémentaires sélectionnées ainsi que le coefficient qui leur est associé pour reconstituer au mieux le module du signal modifié $\tilde{s}(t)$ de FID renseigne sur la nature et la quantification des espèces présentes dans l'échantillon.

De manière alternative et préférée, après l'étape de calcul du module du signal modifié $\tilde{s}(t)$ de FID et sa réintroduction 1315 dans le fichier CSI original on peut lui appliquer une transformée de Fourier. On obtient alors un spectre pour chacun des modules du signal modifié $\tilde{s}(t)$, chacun de ces spectres correspondant à un voxel.

Un nouveau spectre composite $\tilde{S}_{Mod}(\omega) = FFT\left(\left\|\hat{s}(t)\right\|\right)$ est alors obtenu. Cependant, la symétrisation induite par le traitement du module va maintenant mélanger l'UFR du spectre original avec la DFR calculée ne contenant ni bruit ni artéfact. Comme décrit précédemment dans les figures 1 à 9, l'intensité de la résonance des métabolites est toujours divisée par un facteur deux. Dans cette option de mise en oeuvre de l'invention le bruit est également réduit d'un même facteur ce qui laisse le SNR inchangé. Il n'y a donc plus dégradation du SNR comme précédemment.

Comme déjà noté, en présence d'artéfacts antisymétriques de type « sideband », ceux situés dans la DFR seront supprimées par le traitement DFRR 1320. Le seul retrait des « sidebands » dans la DFR compromet leur annulation comme déjà discuté ci-dessus. L'invention décrit ci-après une solution pour résoudre ce problème. On montre aussi que le traitement DFRR peut également être utilisé sans suppression de l'eau.

Bien que l'exemple ci-dessus soit particulièrement avantageux lorsque le procédé s'applique à l'imagerie de type CSI (donc multi-voxels), ce procédé n'est pas limitatif de l'imagerie CSI. On peut en effet l'appliquer à un traitement monovoxel. Dans ce cas, le procédé sera sensiblement le même, hormis les étapes dédiées aux traitements spatial qui n'ont alors plus de raison d'être. L'étape de filtrage spatial est notamment supprimée.

Par ailleurs, bien que le plus souvent les espèces à caractériser se situent à droite du signal de l'espèce de référence, l'invention s'applique également aux cas où les espèces à caractériser se situent à gauche du signal de l'espèce de référence.

Comme indiqué dans la description ci-dessus, de manière très majoritaire, les espèces que l'on cherche à analyser se trouvent à droite du signal de référence. Il peut y avoir des espèces à caractériser à gauche de l'eau, mais elles ne sont généralement pas visibles dans les conditions normales de spectroscopie/spectrométrie telle qu'on la pratique en biomédicale. Néanmoins, l'invention s'étend aux cas où les espèces à caractériser se trouvent à gauche du signal de l'espèce de référence. Dans ce cas, c'est naturellement la portion droite du signal modélisé de l'espèce de référence qui sera substituée à la partie droite du spectre de la FID, la partie de gauche portant les espèces à caractériser étant conservée. Par exemple, il faudra alors soit traiter le spectre en deux temps (on garde dans un cas la DFR, puis on refait le traitement en gardant l'UFR). Il se peut aussi que les espèces de l'UFR n'apparaissent pas à la même distance du signal de référence qu'aucune des espèces de la DFR et que la symétrisation ne pose dans ce cas aucun problème.

La description qui suit de l'invention porte sur les conséquences du traitement DFRR 1320 sur le bruit. Le problème des « sidebands » est traité ensuite.

En ce qui concerne le bruit, il est bien connu que la FFT d'un signal de bruit $n(t)$ ayant une distribution gaussienne de moyenne nulle avec un écart-type $\sigma$ est un signal de bruit tel que :

$$N(\omega) = \sum_{i=1}^{Npts} n(t) e^{j\omega t/N}$$

qui est caractérisé par une distribution gaussienne de moyenne nulle et avec un écart-type $\sigma\sqrt{N}$ en raison du fait que les bruits sont ajoutés d'une façon quadratique. N est le nombre de points dans le temps. Comme la distribution du signal de bruit est centrée autour de zéro, le signal modélisé n'introduit pas de de discontinuité lors du traitement DFRR qui est naturellement le signal nul. Le bruit obtenu en RMN est caractérisé par une répartition gaussienne centrée sur zéro. En l'absence de signal, ce qui est le cas ici, le bruit est donc centré sur l'axe des X. En présence de signal le bruit est naturellement superposé au signal, le retour à la position centrée dépend alors de la largeur de raie du signal (typiquement quelques Hertz pour la largeur à mi-hauteur, mais dans le cas d'une Lorentzienne les ailes sont relativement étendues) et si le signal est intense (l'eau) cela peut être plusieurs centaines de Hertz.

Le traitement DFRR 1320 consiste alors à remplacer la DFR de $N(\omega)$ par des zéros ce qui conduit à obtenir un nouveau signal $\tilde{N}(\omega)$. Sans traitement la iFFT de $N(\omega)$ conduit naturellement à l'obtention du signal de bruit original :

$$n(t) = \frac{1}{N} \sum_{i=1}^{N} N(\omega) e^{-i\pi\omega t/N}$$

avec son écart-type $\sigma$. Mais comme la moitié des points de $N(\omega)$ ont été remplacés par des zéros alors la iFFT $\tilde{N}(\omega)$ conduira à un nouveau signal de bruit :

$$\tilde{n}(t) = \frac{1}{N}\sum_{i=1}^{N}\tilde{N}(\omega)e^{-i\pi\omega t/N}$$

$$= \frac{1}{N}\sum_{i=1}^{N/2}\tilde{N}(\omega)e^{-i\pi\omega t/N}$$

Comme la moitié des points ont une valeur nulle, la somme peut être effectuée sur l'autre moitié. L'écart type $\sigma$ de $\tilde{n}(t)$ est alors égal à $\dfrac{\sigma}{\sqrt{2}}$.

On peut donc dire, et c'est un premier résultat, que l'écart-type du signal de bruit $\tilde{n}(t)$ obtenu lors du traitement DFRR est réduit par un facteur $\sqrt{2}$ lorsque on le compare à l'écart-type du signal de bruit d'origine $n(t)$.

Le traitement des données se poursuit en employant le module des signaux comme cela a été décrit dans les figures 1 à 9 jusqu'à obtenir un nouveau signal comme suit :

$$\tilde{N}_{Mod}(\omega) = FFT\left(\left\|\tilde{n}(t)\right\|\right)$$

Comme expliqué précédemment le module d'un bruit caractérisé par une distribution gaussienne ayant une moyenne centrée sur zéro est distribué selon la loi dite de Rice. Cette répartition peut être approximée par une distribution gaussienne lorsque le RSB est supérieur à 3, et par une distribution de Rayleigh lorsque le RSB tend vers zéro. Les caractéristiques du RSB obtenus dans les deux conditions ci-dessus ont déjà être discutées dans la description des figures 1 à 9. Seule la modification introduite par le traitement DFRR 1320 est discutée plus avant. En ce qui concerne la distribution gaussienne nous avons montré que si $\sigma$ est l'écart-type de $n(t)$ alors celle de $\tilde{N}_{Mod}(\omega) = FFT\left(\left\|\tilde{n}(t)\right\|\right)$ est aussi égale à $\sigma$. En appliquant ceci au spectre composite obtenu comme expliqué ci-dessus l'écart-type de $\tilde{N}(\omega)$ est égal à celui de $\tilde{n}(t)$ qui est lui-même égal à $\dfrac{\sigma}{\sqrt{2}}$. Pour autant que l'approximation gaussienne soit valide l'écart-type du bruit du signal obtenu à l'aide de la transformation DFRR est réduit par un facteur $\sqrt{2}$ par comparaison à l'écart-type obtenu en utilisant le seul traitement du module. C'est exactement la diminution de RSB que l'on observe quand on compare le traitement à l'aide du module avec le traitement conventionnel pour une même approximation gaussienne du bruit. Le traitement DFRR nous permet de retrouver le RSB perdu résultant du traitement du module en présence d'une distribution gaussienne du bruit.

En ce qui concerne la condition ci-dessus dite de Rayleigh, alors que le bruit n'est plus centré, l'analyse est plus complexe. Les caractéristiques de bruit obtenues en vertu de cette approximation sont discutées plus loin.

Dans ce qui suit on introduit une représentation mathématique du traitement DFRR 1320 sur ces deux approximations de distribution de bruit. Ces représentations mathématiques sont ensuite utilisées pour calculer tous les signaux utilisés pour les simulations.

On modélise tout d'abord l'approximation de Rayleigh. Si $r(t)$ est un signal de bruit dans le domaine temporel, et $R(\omega)$ sa transformée de Fourier, remplacer la DFR de $R(\omega)$ par des zéros est strictement équivalent à une multiplication de $R(\omega)$ par l'inverse de la fonction échelon unitaire définie comme suit:

$$\sqcap(\omega) = 0 \text{ if } \omega > 0$$
$$= 1 \text{ if } \omega < 0$$

Le traitement DFRR peut se résumer à :

$$\tilde{R}(\omega) = R(\omega) \times \underline{\phantom{\smile}} (\omega)$$

et la transformée inverse iFFT donne :

$$\tilde{r}(t) = FFT^{-1}\left(R(\omega) \times \underline{\phantom{\smile}}(\omega)\right)$$

si on extrait le module on obtient :

$$\left\|\tilde{r}(t)\right\| = \sqrt{\left\|FFT^{-1}\left(R(\omega) \times \underline{\phantom{\smile}}(\omega)\right)\right\|}$$

et la transformation de Fourier rapide conduit à :

$$\tilde{R}_{Mod}(\omega) = FFT\left(\left\|\tilde{r}(t)\right\|\right)$$
$$= FFT\left(\sqrt{\left\|FFT^{-1}\left(R(\omega) \times \underline{\phantom{\smile}}(\omega)\right)\right\|}\right)$$
$$= FFT\left(\sqrt{\left\|FFT^{-1}(R(\omega)) \otimes FFT^{-1}\left(\underline{\phantom{\smile}}(\omega)\right)\right\|}\right)$$
$$= FFT\left(\sqrt{\left\|r(t) \otimes FFT^{-1}\left(\underline{\phantom{\smile}}(\omega)\right)\right\|}\right)$$

L'approximation gaussienne peut être modélisée par l'ajout au spectre de bruit d'origine $r(t)$ d'un signal constant $c(t)$ défini par :

$$c(t) = c, \quad \forall t$$

Ceci donne un nouveau signal de bruit :

$$g(t) = r(t) + c$$

En utilisant la même notation que ci-dessus on obtient

$$\tilde{G}_{Mod}(\omega) = FFT\left(\sqrt{\left\|g(t)\otimes FFT^{-1}\left(\underline{\Box}(\omega)\right)\right\|}\right)$$

$$= FFT\left(\sqrt{\left\|(r(t)+c)\otimes FFT^{-1}\left(\underline{\Box}(\omega)\right)\right\|}\right)$$

$$= FFT\left(\sqrt{\left\|r(t)\otimes FFT^{-1}\left(\underline{\Box}(\omega)\right)+c\otimes FFT^{-1}\left(\underline{\Box}(\omega)\right)\right\|}\right)$$

$$= FFT\left(\sqrt{\left\|r(t)\otimes FFT^{-1}\left(\underline{\Box}(\omega)\right)+c\right\|}\right)$$

En dépit du fait que $\tilde{G}_{Mod}(\omega)$ ressemble beaucoup à $\tilde{R}_{Mod}(\omega)$ on verra ci-après, dans la section résultats, que la forme du bruit qui en résulte est très différente.

En ce qui concerne les « sidebands », c'est-à-dire les artéfacts antisymétriques autour du signal de l'eau, on a vu que la symétrisation induite par le traitement du module était un moyen simple et efficace pour les éliminer du spectre final. En substituant la DFR du spectre par un modèle de l'eau, les « sidebands » situés dans cette région sont retirés et l'annulation automatique induite par le traitement du module ne se fait plus. Une solution pour continuer d'éliminer les distorsions induites par les « sidebands » dans le spectre l'UFR est la suivante :

- $S_{Mod}(\omega)$ est le spectre obtenu en utilisant le traitement de module seul ;

- $\tilde{S}_{Mod}(\omega)$ est le spectre obtenu en utilisant à la fois le module et le traitement DFRR ;

- $S_{Mod}(\omega)$ ne contient pas d'artéfacts de type « sidebands » alors que $\tilde{S}_{Mod}(\omega)$ en contient encore dans la partie UFR car ils n'ont pas été annulés par la symétrisation ;

- L'UFR du résultat de la soustraction $\tilde{S}_{Mod}(\omega)$ moins $S_{Mod}(\omega)$ contient seulement les « sidebands » et un peu de bruit. Ces « sidebands » peuvent alors être enlevés conduisant à un spectre exempt de contaminations par des artéfacts antisymétriques de type « sidebands ». Le processus représentant cette transformation et la façon dont il est introduit dans le traitement DFRR 1320 apparaît dans le cadre 1350 de la figure 13.

Sur cette figure, l'étape 1351 correspond à la soustraction du spectre $S_{Mod}(\omega)$ au spectre $\tilde{S}_{Mod}(\omega)$ de manière à obtenir les « sidebands » 1352. L'étape 1353 correspond à la soustraction des « sidebands » 1352 au spectre $\tilde{S}_{Mod}(\omega)$ pour obtenir un nouveau spectre 1354 dans lequel les « sidebands » 1352 sont supprimés.

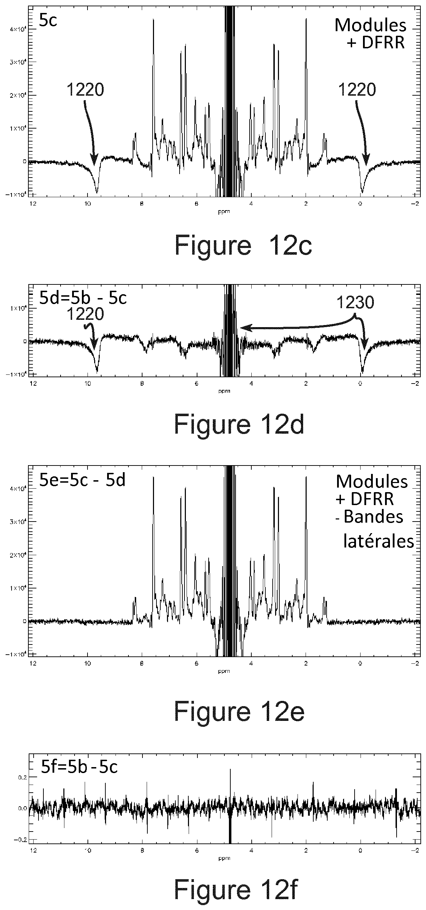

On remarquera que la soustraction 1351 peut être réalisée indifféremment sur la FID dans le comme indiqué en figure 13 ou sur le spectre comme indiqué en figure 12c-12e, la FFT étant distributive par rapport à l'addition.

De manière préférée mais optionnelle, on applique une fonction de lissage à la soustraction obtenue.

Ce mode de réalisation présente notamment pour avantage d'être particulièrement simple, fiable et efficace pour améliorer le RSB. Elle permet ainsi de tirer profit des avantages du module en supprimant automatiquement les artefacts antisymétriques mais sans pour autant pâtir des limitations habituellement induites par le module avec la superposition du bruit présent de part et d'autre de la fréquence de résonance de l'espèce de référence.

Dans ce qui suit, on s'intéresse plus particulièrement au cas des expérimentations de type CSI, c'est-à-dire lorsque l'on analyse plusieurs voxels. Comme indiqué précédemment, la diminution d'un facteur $\sqrt{2}$ du RSB n'était jamais observée en pratique dans les expérimentations in vivo réalisées en mettant en oeuvre le procédé basé sur la prise en compte du module. Dans le cadre de la présente invention, il a été identifié que cela provient du fait que la plupart des exemples présentés ont été extraits d'expérimentations de type CSI et à la façon dont le traitement du module a été mis en œuvre par le processus contenu dans le cadre 1310 de la figure 13. Comme on l'a vu, une FFT 1311 est tout d'abord exécutée dans la dimension spatiale et suivie d'un calcul du module 1314 de chaque voxel de la CSI. Ceci permet de corriger tous les décalages de phase et de fréquence dans le domaine spatial. Ensuite, une transformée inverse iFFT 1317 est effectuée dans la dimension spatiale qui permet d'obtenir un nouvel ensemble de données de l'espace k. Puis, le traitement conventionnel est effectué 1360. Au cours de ce traitement conventionnel on effectue un filtrage spatial.

Le filtrage spatial est applicable dès lors que l'on travaille sur des CSI, qu'elles soient acquises par une ou plusieurs bobines.

On peut appliquer le filtrage spatial:

- soit avant la prise en compte du module, dans le cas où l'on effectue les étapes 1321 à 1326 ou dans le cas où l'on n'effectue pas ces étapes 1321 à 1326.
- soit après la prise en compte du module, dans le cas où l'on effectue les étapes 1321 à 1326 ou dans le cas où l'on n'effectue pas ces étapes 1321 à 1326. On bénéficie alors d'une augmentation du rapport signal sur bruit qui vient s'ajouter à celui procuré par les étapes 1321 à 1326 si elles sont effectuées.

Le filtrage spatial est de préférence réalisé en multipliant la CSi par une fonction en cloche (par exemple gaussienne, cosinus, hanning, hamming, ...) dans la dimension du codage spatial (donc dans l'espace de k), avant la transformation de Fourier spatiale.

L'une des conséquences du filtrage spatial est une diminution de la résolution spatiale, c'est-à-dire une augmentation de la taille des voxels. Cela revient à dire qu'après filtrage spatial le nouveau spectre est le résultat de la somme du spectre original et d'une partie du spectre qui entoure le spectre d'origine. Si le filtrage spatial est effectué après le traitement du module, les spectres de la CSI sont alignés tous ensemble en phase et en fréquence. Cela signifie que quelle que soit la nouvelle taille de voxel obtenue après filtrage tous les voxels impliqués sont alignés ensemble en phase et en fréquence. Cela signifie de plus qu'il n'y a pas d'augmentation de la largeur des raies due à l'augmentation de la taille des voxels. Au contraire, si le filtrage spatial est effectué avant l'extraction du module, les voxels impliqués ne sont donc pas alignés en phase et en fréquence et la résolution du spectre résultant peut en être dégradée conduisant à une diminution du RSB comme cela est illustré dans la section ci-après exposant des résultats.

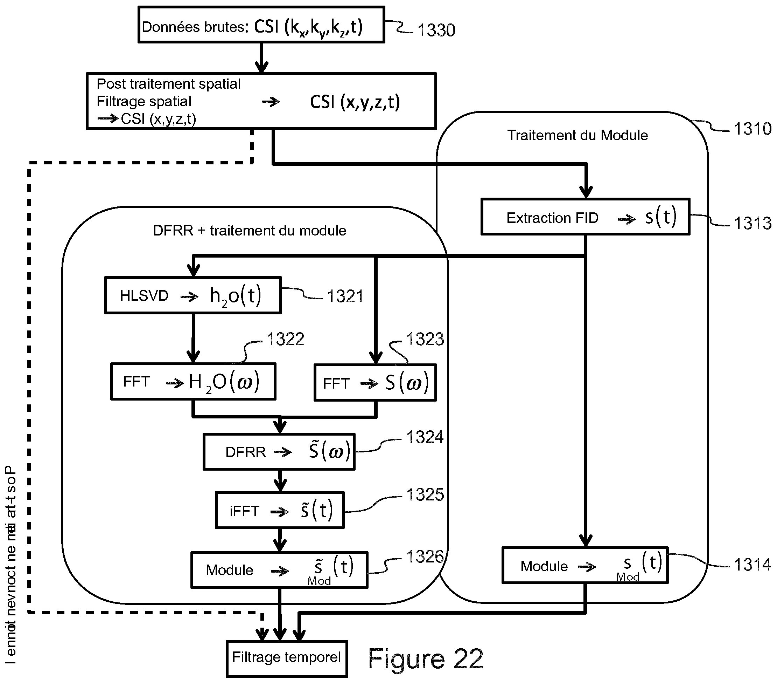

La **figure 22** reprend en partie la figure 13. Les étapes portant les mêmes références que celles de la figure 13 sont identiques à celles décrites précédemment en référence à la figure 13. Cette figure illustre en pointillé le traitement conventionnel (sans prise en compte du module). Elle illustre également le traitement 1310 par le module appliqué au signal S(t) complexe de FID (étape 1314). Cet organigramme illustre également le traitement DFRR associé au traitement par le module (étapes 132 à 1326). Dans ces deux derniers traitements, le filtrage spatial est effectué avant le calcul du module (étapes 1314 ou 1326) avec les conséquences discutées ci-dessus. On préférera donc le cas où ce filtrage spatial est effectué après les étapes 1314 ou 1326.

Sur cette figure le traitement des sidebands, qui n'est qu'une optimisation optionnelle de l'invention ne figure pas.

Dans le cas d'une analyse mono-voxel, le traitement est grandement simplifié puisque tout le traitement spatial disparaît. Les étapes 1311, 1312 et 1317 de la figure 13 n'ont plus lieu d'être et l'étape 1313 devient l'extraction d'une FID parmi celles que l'on a acquises. A l'étape 1326 on a alors une FID que l'on peut quantifier dans le domaine temporel, ou réaliser une transformation de Fourier temporel pour obtenir un spectre que l'on pourra quantifier dans le domaine spectral. Quelle que soit la méthode choisie, la validation finale du résultat se fera de préférence dans le domaine spectral puisque c'est un espace où un opérateur peut juger aisément de la qualité d'un spectre. En effet, RSB, présence ou non d'artefacts, largeur des raies ne peuvent pas être appréciés visuellement par un opérateur dans le domaine temporel.

Dans le cas où on répète plusieurs fois l'expérience pour améliorer le RSB, on réalisera le traitement pour chaque FID avant de les sommer (à l'étape 1315) de la figure 13. Les étapes comprises entre 1313 et 1315 de la figure 13 peuvent remplacer les étapes 340 de la figure 3, l'étape « calcul du Module de chaque FID » de la figure 5 (dans le cas où le module est calculé après le filtrage spatial) et l'étape 340 de la figure 8, comme cela ressort de la description qui précède.

Dans ce paragraphe le cadre expérimental pour les applications in vivo et in vitro de l'invention est plus particulièrement décrit. Les hypothèses retenues pour la mise en oeuvre de l'invention ont d'abord été vérifiées sur des simulations puis expérimentalement. Les expérimentations in vivo ont été conduites à partir d'un équipement RMN de type « scanner » pouvant développer un champ d'une valeur de 3 tesla (Verio, Siemens Médical Solution, Erlanger, Allemagne) en utilisant une séquence d'impulsions, dite OVS-CSI, spécifique. La plupart des spectres présentés dans la section des résultats ci-après sont extraits d'expérimentations CSI obtenues avec 25x25 pas de codage de phase, une pondération de type circulaire, et un temps d'écho court. « 25x25 circular weighted short echo time » avec ou sans une faible suppression de l'eau. Les paramètres d'acquisition sont les suivants: TR/TE = 1500/16 millisecondes, points d'échantillonnage = 2000, SW = 2000 hertz. Le champ de vision est de 240x240 millimètres (mm) et la tranche est de 20 mm d'épaisseur. Le temps total d'acquisition est de 11 minutes et 7 secondes. Les résultats d'expérimentations CSI avec des temps d'écho longs sont également présentés notamment avec un temps d'écho de 135 ms, tous les autres paramètres restant identiques. Le traitement postérieur a été effectué en utilisant un logiciel spécifique dit CSIAPO qui applique un filtrage spatial dit de Hanning, un remplissage par des zéros des données acquises sur 8000 points d'échantillonnage dans le domaine temporel et le retrait du signal résiduel de l'eau en utilisant la technique HLSVD. Tous les spectres obtenus à l'aide du traitement du module seul ou avec le traitement du module plus DFRR, sont multipliés par un facteur deux afin de compenser la réduction de l'intensité du signal par le même facteur induit par le traitement du module. Ces spectres sont alors plus faciles à comparer visuellement avec les spectres obtenus avec le traitement conventionnel des signaux.

Dans la description qui suit de l'invention on décrit tout d'abord les résultats des simulations effectuées pour vérifier les hypothèses de mise en oeuvre de l'invention.

Afin de visualiser la forme du signal de bruit obtenu, respectivement, avec une distribution de type Rayleigh et avec l'approximation gaussienne, deux signaux de bruit complexes ont été générés en utilisant un logiciel dit « IDL » développé par la société « Interactive Data Language, Research Systems Inc. » située à Boulder, Colorado aux USA. Le premier signal $r(t)$ 1411 consiste en une distribution normale, au sens statistique de ce terme, composée de deux fois 4000 échantillons formant une séquence pseudo-aléatoire avec une moyenne de zéro et un écart-type de 10 et représentant la distribution de Rayleigh. Le deuxième signal $g(t)$ 1412 est obtenu en ajoutant un signal constant d'une amplitude de 50. Il représente la distribution gaussienne.

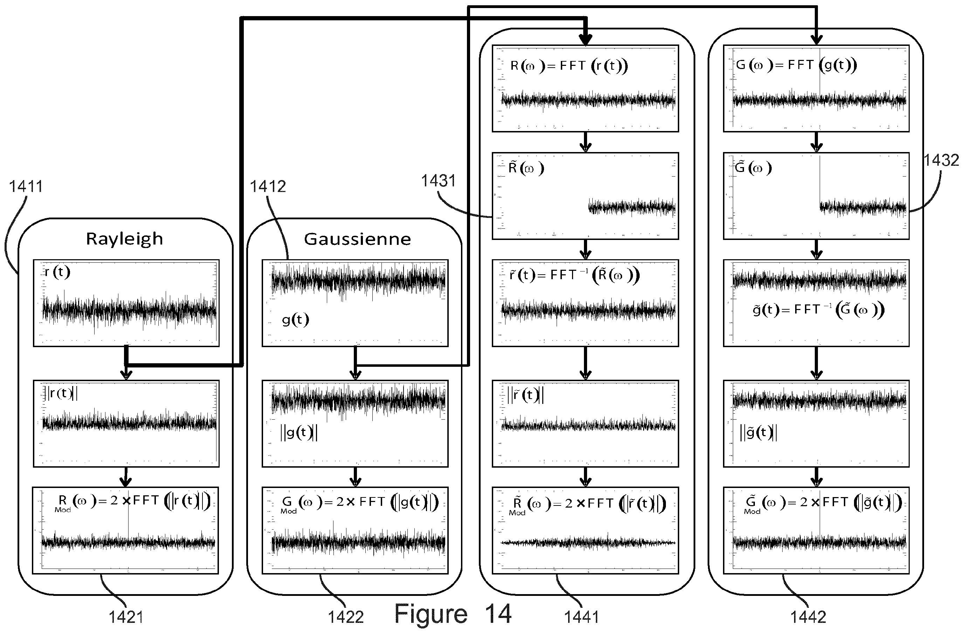

La **figure 14** illustre les résultats obtenus sur ces deux signaux de bruit à chaque étape du traitement en utilisant soit le traitement module seul, ou le traitement module avec DFRR. Pour le traitement du module, les deux modules $\|r(t)\|$ et $\|g(t)\|$ sont extraits et après la transformation FFT les spectres de bruit $R_{Mod}(\omega)$ et $G_{Mod}(\omega)$ sont obtenus. Comme déjà discuté, ces signaux de bruit sont multipliés par un facteur deux afin de compenser la perte de l'amplitude du signal induite par le traitement du module. La modification du RSB peut alors être estimée visuellement par la seule évaluation de l'amplitude du bruit. En ce qui concerne le traitement DFRR, on applique sur les signaux $r(t)$ et $g(t)$ une transformée de Fourier qui conduit respectivement à l'obtention des signaux $R_{Mod}(\omega)$ 1421 et $G_{Mod}(\omega)$ 1422, c'est-à-dire les signaux de bruit qu'on obtiendrait à l'aide du traitement conventionnel. La DFR de chaque signal est alors remplacée par des zéros, opération à l'issue de laquelle on obtient $\tilde{R}(\omega)$ 1431 et $\tilde{G}(\omega)$ 1432. Ensuite, on applique sur ces deux signaux une transformée de Fourier inverse ou iFFT, le module est extrait puis on applique à nouveau une FFT et on multiplie par un facteur deux pour la même raison que précédemment, ce qui conduit au résultat final $\tilde{R}_{Mod}(\omega)$ 1441 et $\tilde{G}_{Mod}(\omega)$ 1442.

Si on considère plus particulièrement le signal $\tilde{R}_{Mod}(\omega)$ 1441 on peut voir clairement que le traitement DFRR conduit à obtenir un bruit non uniforme dans la dimension spectrale. Il faut se rappeler que la condition de Rayleigh est celle qui ne donne aucune dégradation du RSB lorsqu'on utilise le traitement du module seul ($R_{Mod}(\omega))$ ce qui doit être comparé au traitement conventionnel ($R(\omega)$). Lorsque le traitement DFRR est ajouté ($\tilde{R}_{Mod}(\omega))$ le bruit autour du centre de la fenêtre spectrale est sensiblement de même intensité que celle obtenue en utilisant le traitement du module seul alors qu'une diminution de l'intensité du bruit peut être observée lorsque on se déplace vers les bords de la fenêtre spectrale.

Si maintenant on considère plus particulièrement le signal $\tilde{G}_{Mod}(\omega)$ on peut voir clairement que l'amplitude du bruit est diminuée en comparaison à $G_{Mod}(\omega)$. Elle est comparable à celle de $G(\omega)$ qui est le bruit obtenu quand le traitement conventionnel est utilisé.

Les tableaux 1a et 1b ci-après donnent l'écart-type du bruit obtenu à différentes étapes intéressantes quand cette simulation est répétée 1000 fois. Le tableau 1a montre les résultats obtenus dans le domaine du temps et le tableau 1b dans le domaine fréquentiel. A nouveau, les signaux obtenus après traitement du module, avec ou sans traitement DFRR, sont multipliés par un facteur deux pour compenser la perte d'intensité du signal créée par ce traitement. L'écart-type du bruit est alors directement lié au RSB.

| 1a | $r(t),g(t)$ | $\tilde{r}(t),\tilde{g}(t)$ |
|---|---|---|
| Ecart-type | $\sigma$ | $\dfrac{\sigma}{\sqrt{2}}$ |
| Mesuré (calculé) | 10.0 (10.0) | 7.07 (7.07) |

| 1b | $R(\omega), G(\omega)$ | $R_{Mod}(\omega) \times 2$ | $G_{Mod}(\omega) \times 2$ | $\tilde{R}_{Mod}(\omega) \times 2$ (centre) | $\tilde{R}_{Mod}(\omega) \times 2$ (bord) | $\tilde{G}_{Mod}(\omega) \times 2$ |
|---|---|---|---|---|---|---|
| Ecart-type | $\sigma\sqrt{N}$ | $\sigma\sqrt{2N}$ | $\sigma\sqrt{N(4-\pi)}$ | ? | ? | $\sigma\sqrt{N}$ |
| Mesuré (calculé) | 640.5 (640) | 895.0 (905.1) | 593.0 (592.6) | 576.1 | 138.3 | 637.3 (640) |

On peut voir sur ce tableau que dans les régions où le bruit du signal FID original suit une distribution gaussienne, c'est-à-dire avec un écart-type qui tend vers zéro, le RSB des spectres obtenus en utilisant le traitement du module avec DFRR est en augmentation d'un facteur $\sqrt{2}$ quand on le compare au RSB des spectres obtenus en utilisant le traitement du module seul. Le RSB obtenu en utilisant le module avec DFRR est alors le même que celui obtenu en utilisant le traitement conventionnel. Dans la région où le bruit du signal FID original suit une loi de Rayleigh, c'est-à-dire quand le RSB du FID est supérieur à 3, le RSB des spectres obtenus en utilisant le traitement du module avec DFRR est alors même plus élevé que celui obtenu en utilisant le traitement conventionnel. Ce gain peut aller jusqu'à un facteur de 4,6 près des limites de la fenêtre spectrale. Dans la pratique, ces deux régions sont présentes dans un signal FID acquis et le RSB résultant est compris entre ces deux limites selon le rapport qui existe entre le bruit qui peut être approximé par une distribution gaussienne et celui qui se rapproche d'une distribution de Rayleigh dans le signal FID original.

Si, pour diverses raisons, la condition pour que la loi Rayleigh s'applique n'est pas souhaitable, il faut noter qu'il est possible d'ajouter un signal constant juste avant l'extraction du module et le retirer après extraction de celui-ci. Si la valeur du signal constant est choisie pour être supérieure à trois fois l'écart-type du bruit du signal FID original, la condition pour considérer que la distribution est gaussienne est alors satisfaite. Le RSB des spectres obtenus en utilisant le traitement du module avec DFRR sera la même que celui du spectre obtenu par le traitement conventionnel. Le gain en RSB sera perdu mais le bruit du spectre résultant sera alors plat. Le cadre 1370 de la figure 13 montre comment ce traitement supplémentaire peut être introduit dans le traitement de la DFRR 1320.

Toutes les hypothèses permettant la mise en oeuvre de l'invention ont également été vérifiées in vivo et in vitro comme décrit dans la section suivante. On y compare les résultats obtenus avec le traitement DFRR, le traitement du module seul et le traitement conventionnel. Des données RMN spectroscopiques/spectrométriques in vivo du cerveau et in vitro d'un « fantôme » ont été obtenues en utilisant les conditions expérimentales décrites précédemment.

De manière connue, un fantôme est un modèle de ce que l'on veut étudier. Par exemple, il peut s'agir d'un récipient contenant de l'eau et quelques un des métabolites que l'on retrouve dans le cerveau.

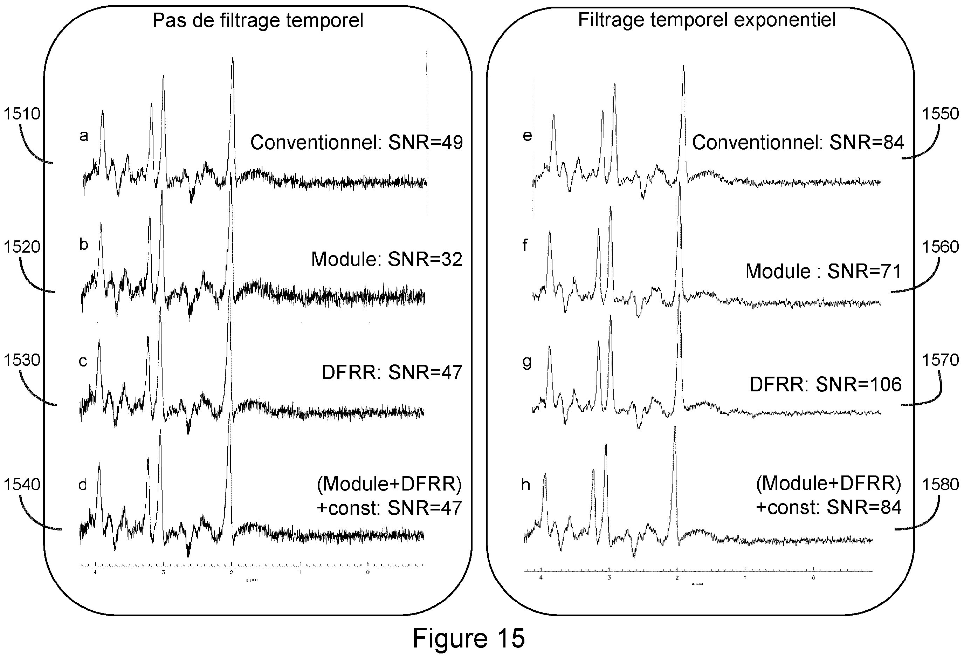

La **figure 15** montre huit spectres extraits d'un même voxel d'une acquisition CSI avec écho long sur un cerveau sans suppression de l'eau. Les graphiques 1510, 1520, 1530 et 1540 représentent chacun un spectre obtenu à l'aide du traitement, respectivement, conventionnel, du module, du module avec DFR et avec ajout d'un signal constant. Ceci est fait sans apodisation dans le domaine temporel afin de maximiser la contribution gaussienne du bruit. Il s'agit en fait de multiplier la FID par une exponentiel décroissante qui privilégie le début de la FID (c'est-à-dire la région où il y a du signal) et atténue la fin de la FID (ou il ne reste que du bruit). Les graphiques 1550, 1560, 1570 et 1580 montrent les spectres obtenus en utilisant les mêmes traitements mais en ajoutant un filtrage temporel exponentiel d'une largeur de bande égale à 0,5 afin de privilégier les conditions d'obtention d'une distribution de Rayleigh.

Les RSB obtenus grâce aux différentes techniques de traitement utilisées sont reportés sur la figure 15 et on peut vérifier que lorsque la condition gaussienne est privilégiée (1520, 1530 et 1580), le RSB obtenu par le traitement conventionnel est recouvré en utilisant le traitement DFRR.

Nous pouvons aussi vérifier sur cet exemple que l'ajout d'une constante au signal FID avant l'extraction du module, puis son retrait du signal FID dans les régions où la loi de Rayleigh s'applique 1580 conduit à diminuer le RSB du spectre résultant par comparaison avec les spectres obtenus lorsque la condition de Rayleigh est privilégié 1570. Le RSB du spectre résultant est alors le même que celui obtenu en utilisant le traitement conventionnel. Il faut aussi noter qu'une baisse du RSB d'un facteur $\sqrt{2}$ est effectivement obtenue quand on compare le traitement conventionnel 1510 avec le traitement du module 1520. Ceci est dû, dans ces cas particuliers au fait que le traitement du module et de la DFRR sont réalisés après le filtrage spatial afin d'éliminer le gain en RSB qui peut être obtenu quand ils sont effectués avant comme discuté précédemment (expérimentations CSI). Les résultats présentés proviennent par exemple d'une CSI obtenue avec 25x25 pas de codage. Ces résultats seraient comparables à ceux obtenus par une expérimentation monovoxel. Dans le cas de la figure 15 on illustre ce qu'apporte le traitement DFRR seul. Le traitement par le module a été réalisé après l'apodisation spatiale afin de ne pas rajouter le gain en RSB obtenue lorsqu'on le fait avant. De ce fait les résultats de cette figure, bien qu'ayant été obtenus sur une CSI, sont équivalents à ceux que l'on aurait obtenus sur un monovoxel.

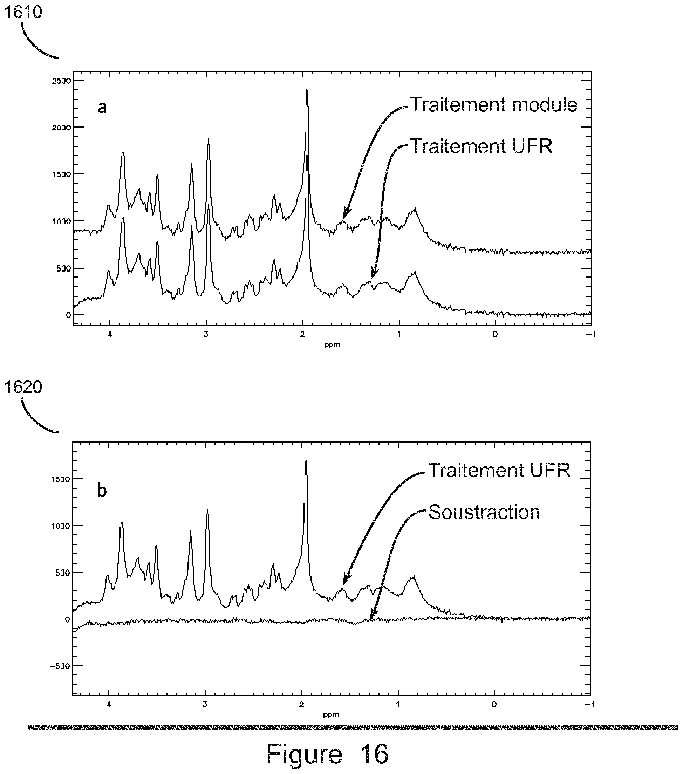

La **figure 16** montre deux spectres d'un même voxel d'une acquisition CSI avec écho court effectuée sur un cerveau avec une suppression partielle uniquement de l'eau ceci afin de minimiser les « sidebands ». Le diagramme 1610 montre le spectre obtenu en utilisant le traitement du module seul et le spectre obtenu avec le traitement DFRR. Le diagramme 1620 montre le résultat de la soustraction entre le spectre obtenu à l'aide du traitement DFRR et celui du module seul. On voit sur cette courbe, résultat de la soustraction, qu'il n'y a pas de signal résiduel provenant des métabolites. Le signal de soustraction est composé uniquement du bruit et des artefacts qui sont probablement des « sidebands ».

**EP 2 939 046 B1**

Comme on l'a vu précédemment, des artéfacts antisymétriques de type « sidebands » sont clairement identifiables sur la figure 12a qui correspond à une acquisition CSI avec écho court sur un fantôme qui contient plusieurs métabolites afin de mimer un spectre de cerveau. Les figures 12a et 12b déjà décrites et la **figure 12c** montrent, respectivement, les spectres obtenus à l'aide d'un traitement conventionnel, avec le module seul et avec le module plus la DFRR. Comme déjà décrit, les « sidebands » sont enlevés lors du traitement du module seul mais pas dans le cas du traitement module plus DFRR comme on peut le constater 1220. La **figure 12d** montre le résultat de la soustraction entre les spectres des figures 5b et 5c, c'est-à-dire la différence entre module seul et module plus DFRR. On y retrouve clairement de l'eau résiduelle entre 4 et 4,95 ppm 1230, et les bandes latérales. La **figure 12e** montre le spectre obtenu lorsque ce signal est soustrait du signal après traitement du module avec DFRR, c'est-à-dire celui de la figure 5c. On peut voir sur le spectre de la figure 12e que les « sidebands » sont alors effectivement supprimés, et que ce spectre est très identique à celui obtenu en utilisant le module de traitement seulement, c'est-à-dire celui de la figure 12b. La **figure 12f** représente le résultat de la soustraction entre le spectre obtenu à l'aide du traitement du module seul et le spectre obtenu après soustraction des « sidebands » par la méthode DFRR. Ce spectre comprend essentiellement les éventuels artéfacts de type « sidebands ». Par conséquent, ce résultat confirme clairement que le procédé DFRR est très efficace pour éliminer les éventuelles sidebands.

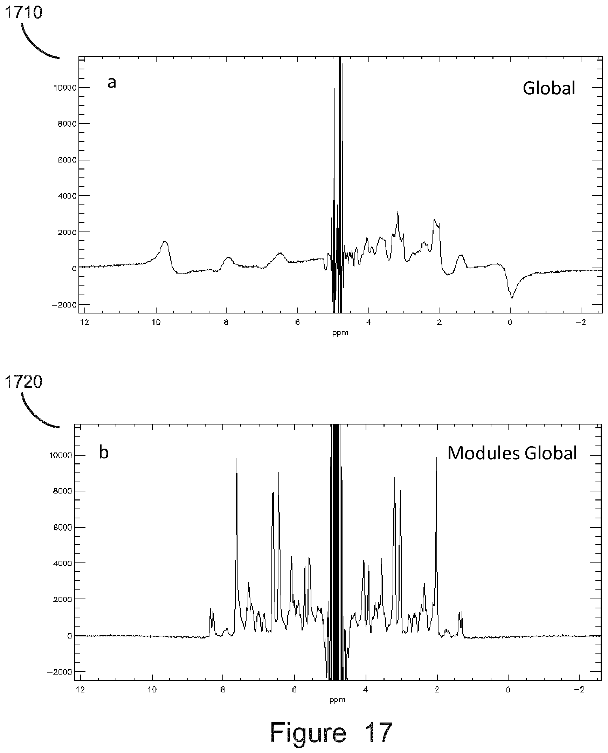

La **figure 17** illustre les différences qui peuvent être obtenues lorsqu'on utilise le traitement du module avant ou après le filtrage spatial sur une acquisition CSI avec écho court sur un fantôme qui imite un spectre de cerveau. De préférence, le filtrage spatial consiste dans ce cas à multiplier les lignes et les colonnes de la CSI par une fonction de hanning avant transformation de Fourier spatiale (donc dans l'espace des k). Les diagrammes 1710 et 1720 montrent le spectre global obtenu en sommant tous les spectres de la CSI. Le diagramme 1710 montre les spectres obtenus en n'utilisant pas de traitement du tout, le spectre obtenu est le spectre de l'ensemble de la partie excitée de l'échantillon, c'est-à-dire 2 cm, qui correspond à l'épaisseur de tranche choisie par la séquence d'impulsions dans ce cas.

Comme mentionné précédemment, le filtrage spatial a pour conséquence de sommer les spectres de voxel voisins. Afin de démultiplier le phénomène, cette figure somme tous les spectres de la CSI. Le diagramme 1710 représente ce que l'on obtient si l'on somme les spectres avant prise en compte du module (ce qui amplifie ce que l'on aurait obtenu si l'on avait réalisé un filtrage spatial avant prise en compte du), et 1720 si l'on applique le module avant de sommer les spectres.

La résolution basse fréquence que l'on peut noter sur ce spectre est due à la difficulté d'homogénéiser le champ magnétique sur un si grand volume. Le diagramme 1720 montre le spectre obtenu en sommant tous les spectres de la CSI, obtenu en utilisant le traitement par le module tel que représenté dans le cadre 1310 de la figure 13.

Cette figure 17 illustre encore clairement que la résolution spatiale est considérablement améliorée. Le traitement par le module agit dans ce cas comme si une très haute homogénéité du champ B0 avait été obtenue lors de l'acquisition, alors que cette apparente bonne homogénéité résulte du traitement. Ceci ouvre une nouvelle perspective dans le cas où un monovoxel doit être acquis sur un gros volume, donc un champ difficile à homogénéiser. Il peut en effet être intéressant d'envisager d'acquérir une CSI à la place, puis de réaliser le traitement par le modulus pour obtenir in fine un spectre de bonne qualité. Cette technique est grandement simplifiée par la prise en compte du module tel que proposé par l'invention.

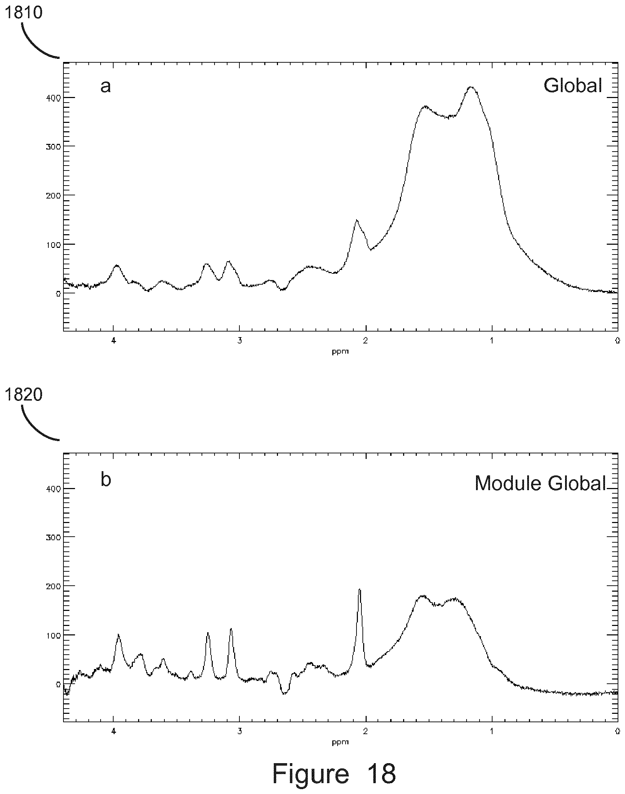

La **figure 18** montre les résultats obtenus en utilisant le même schéma à partir d'une acquisition CSI avec écho long sur un cerveau. On peut encore observer un gain en résolution spectrale obtenue avec le traitement du module par comparaison avec le spectre obtenu à partir des données brutes. Il faut aussi noter que dans certains voxels le signal de lipides peut être supérieur à celui de l'eau. Dans ce cas le signal des lipides est pris comme référence par le traitement du module. Les spectres de ces voxels sont alors alignés en phase et en fréquence en fonction de la résonance de ces lipides. Heureusement, dans la spectroscopie/spectrométrie du cerveau une telle région ne contient pas de résonance intéressante. En outre, si le maximum de la résonance des lipides est environ à 0,8 ppm, il sera shifté à 4.7 ppm (la position de la résonance de l'eau). La résonance de l'eau sera alors séparée en deux parties (due à la symétrisation induite par la prise en compte du Module) qui se retrouveront positionnées, environ à 8,8 et -0,8 ppm, ce qui correspond fort heureusement à une région située en dehors de la région intéressante. On voit sur la figure 18 que le spectre d'intérêt est situé entre 2 ppm (le NAA) et 4 ppm (la créatine). Le pic situé à environ 2ppm correspond aux NAA et le pic situé à environ 4ppm correspond à la créatine. Le massif situé entre 0,8 et 1,8 ppm est celui des lipides. Cependant, cet effet va agir comme un traitement postérieur de suppression des lipides puisque dans tous les voxels où le signal des lipides est plus élevé que le signal de l'eau, le signal lipidique sera réaffecté à la résonance de l'eau et sera supprimé avec le signal de l'eau par la suppression de l'eau résiduelle. C'est la raison pour laquelle le signal des lipides est plus élevé sur le spectre obtenu sans traitement du module 1810 qui se compare au spectre obtenu avec traitement du module 1820.

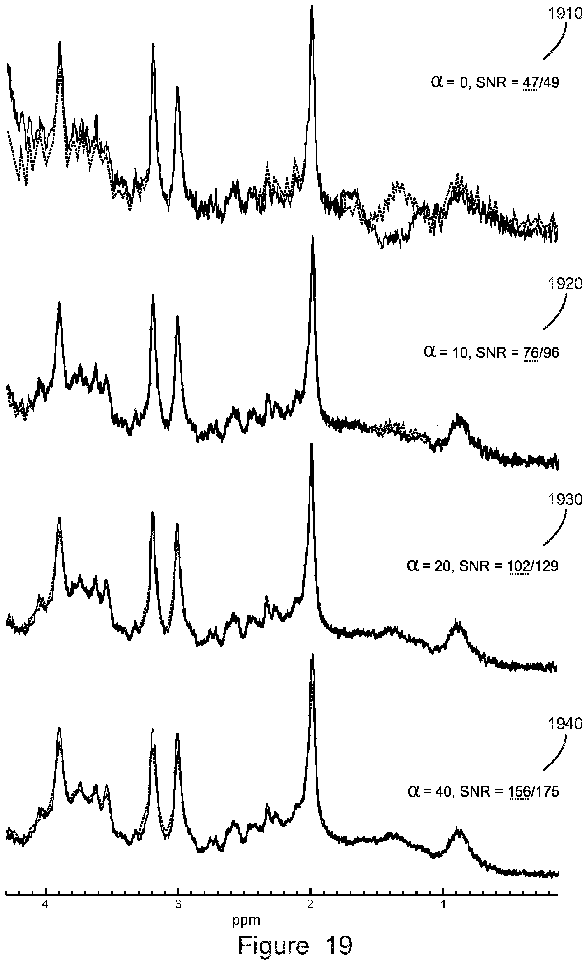

La **figure 19** montre l'influence de l'application du traitement par le module avant ou après le filtrage spatial sur une acquisition CSI d'un cerveau avec écho long. Dans ce cas, la fonction de filtrage spatial est une fenêtre dite de Kaiser-Bessel. La figure 19 montre les spectres obtenus lorsque le module est effectué avant (en pointillés) et après (en traits pleins).

Plus $\alpha$ est élevé, plus le filtre est étroit donc plus le filtrage est fort. Or, plus le filtrage est fort, plus la taille du voxel s'agrandit donc plus le nombre de voxels voisins dont le signal vient s'ajouter au voxel considéré est important. Par ailleurs, les signaux qui viennent s'ajouter au voxel considéré proviennent de régions qui sont de plus en plus éloignées du voxel considéré, donc de régions où le spectre à le plus de chance d'être déphasé et shifté par l'inhomogénéité du champ magnétique B0. Pour $\alpha=0$ il n'y a pas de filtrage spatial, et les RSB des deux spectres sont équivalents. Pour $\alpha>0$ on observe que le RSB obtenu lorsque le traitement par le module est réalisé avant le filtrage spatial est meilleur que celui que l'on obtient lorsqu'il est réalisé après, et que l'écart entre les deux RSB augmente avec $\alpha$ (donc avec la taille du voxel). On retrouve ici la caractéristique mentionnée précédemment qui porte sur le fait que la perte en RSB théorique que l'on s'attend à avoir du fait du traitement par le module n'est pas obtenue dans le cas de la CSI si le filtrage spatial est réalisé après l'extraction du module.

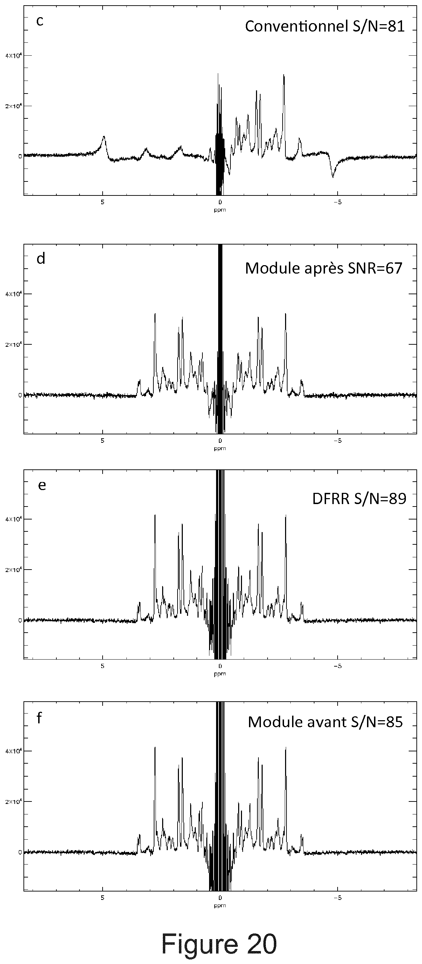

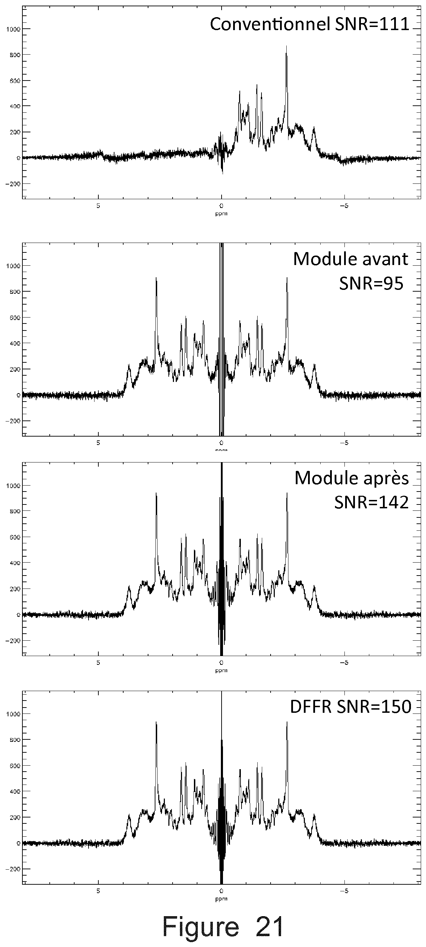

Les **figures 20 et 21** illustrent cet effet sur une acquisition CSI effectuée d'une part sur un fantôme (figure 20) et, d'autre part, sur un patient (figure 21).

Chacune de ces figures comprend les spectres suivants illustrés depuis le haut vers le bas de ces figures :

- spectre obtenu par la méthode conventionnelle,

- spectre obtenu par la méthode du module telle que décrite en référence aux figures 1 à 9, avec prise en compte du module après filtrage spatial,

- spectre obtenu par la méthode DFRR,

- spectre obtenu par la méthode du module telle que décrite en référence aux figures 1 à 9, avec prise en compte du module avant filtrage spatial.

Ces spectres font apparaître que la technique DFRR et la technique d'utilisation du module avant filtrage spatial permettent d'obtenir des RSB très satisfaisants voire améliorés par rapport à la méthode conventionnelle. Ce gain en termes de RSB est encore plus manifeste sur la figure 21. Ceci est sans doute dû aux inhomogénéités du champ magnétique qui sont plus élevées sur un témoin que sur un fantôme.

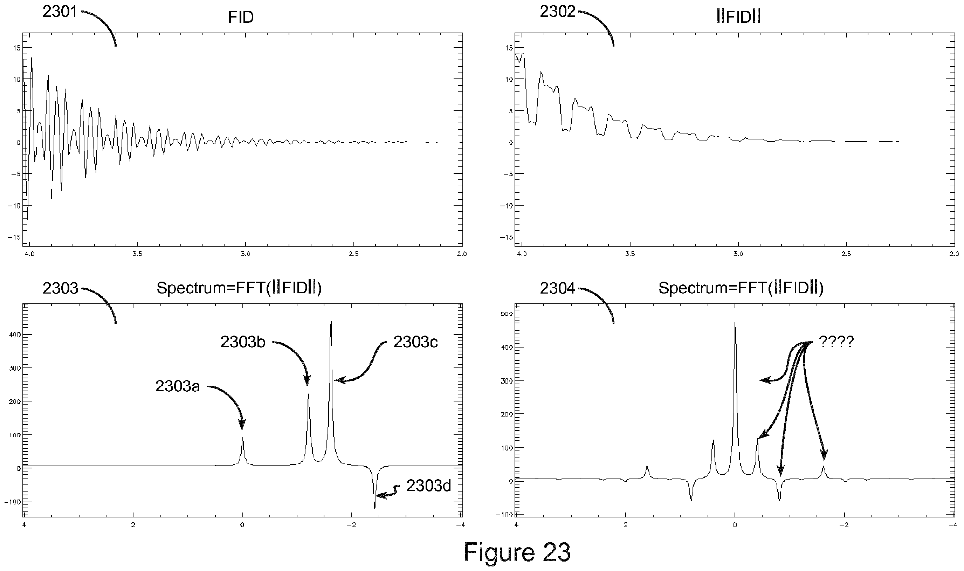

La figure 23 illustre clairement que lorsque l'échantillon comprend plusieurs espèces à caractériser, l'invention nécessite la présence d'une espèce de référence présente en grande quantité afin de servir de porteuse pour les espèces à caractériser. En effet, la prise en compte du module impacte la porteuse tout en permettant de comparer cette dernière aux signaux des espèces à caractériser.

L'invention est ainsi clairement différente de techniques qui visent à analyser le temps de relaxation d'une seule espèce et pour laquelle la fréquence du champ magnétique est adaptée.

L'invention s'applique en particulier à la spectroscopie/spectrométrie qu'elle soit mono-voxel ou multi-voxels (CSI).

Supprimer le signal de l'eau lors de l'acquisition, puis appliquer le module au signal obtenu rendrait toute quantification des métabolites impossible. Cela apparaît clairement sur la figure 23 qui concerne une spectroscopie/spectrométrie. La FID 2301 est obtenue après suppression quasiment complète du signal de l'eau, cette suppression étant effectuée à l'acquisition. La FID 2302 est obtenue après suppression quasiment complète du signal de l'eau et après prise en compte du module. Le spectre 2303 est le spectre obtenu par transformée de Fourier de la FID 2301 et correction de phase manuelle. Sur le spectre 2303, les métabolites sont identifiables et quantifiables. Ce spectre 2303 reproduit fidèlement la composition de l'échantillon. Le pic 2303a correspond au signal résiduel de l'eau et les pics 2303b-c correspondent aux métabolites. 2301 et 2303 correspondent ainsi au traitement conventionnel.

Le spectre 2304 est le spectre obtenu par transformée de Fourier de la FID 2302. Ce spectre est inexploitable. Il est très différent du spectre 2303 et les métabolites ne sont ni identifiables ni quantifiables. Du fait de l'acquisition avec suppression du signal de l'espèce de référence, la prise en compte du module fausse toute interprétation.

En pratique, lorsque l'espèce de référence est présente en quantité bien supérieure à celle de l'espèce à caractérisée, le signal de l'espèce de référence formera une porteuse pour les signaux des autres espèces.

Dans les analyses in vivo avec l'eau comme espèce de référence, cela sera toujours le cas puisque l'eau est présente en quantité supérieure à $10^3$. Le plus souvent elle est présente en quantité supérieure à $10^5$ voire $10^6$ fois la quantité des autres espèces. Ainsi, quel que soit le temps de relaxation des espèces, le signal de l'eau formera une porteuse pour les signaux des autres espèces et la prise en compte du module ne fera pas disparaître l'information de phase des signaux des espèces présentes en plus petite quantité que l'eau.

Dans d'autres cas, où l'espèce de référence est initialement présente en quantité majoritaire mais d'un facteur 2, par exemple, et si les temps de relaxation de l'espèce de référence et de l'espèce à caractériser sont significativement différents, alors il peut être recommandé de modifier la composition de l'échantillon en effectuant au moins l'une des étapes suivantes :

- ajout de solvant dans la solution pour augmenter sa teneur et donc pour augmenter le signal de l'espèce de référence et lui faire pleinement jouer un rôle de porteuse ;
- ajout dans l'échantillon d'une espèce ne produisant pas de signal (pas de fréquence de résonance) mais qui modifie les temps de relaxation. Tel est le cas du $CuSO_4$ par exemple.

Bien que la description détaillée se réfère à titre d'exemple à la caractérisation de métabolites d'un échantillon biologique, la présente invention s'avère également avantageuse pour l'analyse d'une composition chimique non biologique. En effet, l'invention permet par exemple d'identifier des composés chimiques dans une solution comprenant une espèce de référence telle que de l'eau ou tout autre solvant et de mesurer la teneur de ces composés dans cette solution.

En outre, l'invention s'applique quelle que soit la nature de l'espèce de référence. Cette espèce de référence est souvent de l'eau comme indiqué dans les exemples précédents mais peut être une autre espèce, par exemple un solvant différent de l'eau.

L'invention n'est pas limitée aux modes de réalisation décrits mais s'étend à tout mode de réalisation couvert par les revendications.

## Revendications

1. Procédé d'analyse spectroscopique par résonance magnétique nucléaire (RMN) d'au moins un échantillon comprenant au moins une espèce à caractériser ainsi qu'une espèce de référence dont la teneur dans l'échantillon est supérieure à deux fois la teneur de l'au moins une espèce à caractériser, le procédé comprenant les étape suivantes :

    a. application d'au moins un champ $B_0$ constant sur l'au moins un échantillon,
    b. acquisition (310, 1313) par une ou plusieurs antennes d'un ou plusieurs signaux S(t) complexes de décroissance libre d'induction (FID), chaque signal S(t) complexe de FID comprenant une partie réelle (140) et une partie imaginaire (150) ; le procédé comprenant, préalablement à l'étape d'acquisition, une étape de fourniture de l'au moins un échantillon, l'étape de fourniture étant effectuée de sorte que les teneurs relatives de l'espèce de référence et de l'au moins une espèce à caractériser ainsi que leurs temps relatifs de relaxation soient tels que dans chaque signal S(t) complexe de FID l'amplitude du signal de l'espèce de référence soit au moins deux fois supérieure à l'amplitude de celui de l'au moins une espèce à caractériser;
    **caractérisé en ce que** :

        - l'étape de fourniture de l'échantillon est effectuée de telle sorte que l'échantillon ne présente pas de signal de part et d'autre de la fréquence correspondant à celle de l'espèce de référence ; et

            • soit le procédé comprend également au moins les étapes suivantes :

                - pour chaque signal S(t) complexe de FID, calcul (340, 1314) du module de chaque signal S(t) complexe de FID ;
                - après calcul (340) du module de chaque signal S(t) complexe de FID, une étape (230) d'application d'une transformée de Fourier à un signal prenant en compte ledit module (222) de FID ;
                - identification de la nature et de la teneur de l'au moins une espèce à caractériser à partir du module de chaque signal S(t) complexe de FID ;

            • soit le procédé comprend également les étapes suivantes après l'étape d'acquisition (310, 1313) par une ou plusieurs antennes d'au moins un signal S(t) complexe de FID:

                - obtention (1323) d'un spectre S($\omega$) de FID par application d'une transformée de Fourier aux parties réelle et complexe de l'au moins un signal S(t) complexe de FID, le spectre S($\omega$) de FID obtenu comportant alors l'espèce de référence et l'espèce à caractériser et présentant deux portions (UFR, DFR) s'étendant chacune à partir de la fréquence de résonance de l'espèce de référence ($F_{0Ref}$) et respectivement de part et d'autre de $F_{0Ref}$, au moins une fréquence de l'espèce à caractériser étant située sur une première portion de spectre prise parmi lesdites deux portions (UFR, DFR);
                - modélisation (1321) du signal de l'espèce de référence Sref(t) à partir des parties réelle et complexe de l'au moins un signal complexe S(t) de FID ;
                - obtention (1322) d'un spectre Sref($\omega$) de l'espèce de référence par application d'une transformée de Fourier à la modélisation du signal de l'espèce de référence Sref(t), le spectre Sref(w) de l'espèce de référence présentant alors deux portions de spectre s'étendant à partir de la fréquence de résonance de l'espèce de référence ($F_{0Ref'}$) du spectre Sref($\omega$) et s'étendant respectivement de part et d'autre de $F_{0Ref}$;

- obtention (1324) d'un spectre modifié $\tilde{S}(\omega)$ de FID, par substitution d'une seconde portion du spectre S($\omega$) de FID, ladite seconde portion étant la portion prise parmi lesdites deux portions (UFR et DFR) du spectre S($\omega$) et qui ne comporte pas l'espèce à caractériser, par la portion du spectre Sref($\omega$) prise parmi les deux portions de spectre s'étendant à partir de $F_{0Ref}$ du spectre Sref($\omega$) et qui s'étend du même côté que ladite seconde portion du spectre S($\omega$);

- application (1325) d'une transformée de Fourier inverse au spectre modifié $\tilde{S}(\omega)$ pour obtenir dans le domaine temporel un signal modifié $\tilde{s}(t)$ de FID ;

- calcul (1326) du module du signal modifié $\tilde{s}(t)$ de FID ;

- identification de la nature et de la teneur de l'au moins une espèce à caractériser à partir du module du signal modifié $\tilde{s}(t)$ de FID ; ∘ et le procédé comprend les étapes suivantes effectuées après l'étape de calcul (340, 1314) du module de chaque signal S(t) complexe de FID, après l'étape de calcul (1326) du module du signal modifié $\tilde{s}(t)$ de FID :

> - soustraction (1351) du module du signal S(t) complexe de FID au module du signal modifié $\tilde{s}(t)$ de FID ;
> - soustraction (1354) du résultat obtenu à l'étape précédente au module du signal modifié $\tilde{s}(t)$ de FID ;
> Ou

∘ le procédé comprend les étapes suivantes effectuées après l'étape de calcul (340, 1314) du module de chaque signal S(t) complexe de FID, après l'étape de calcul (1326) du module du signal modifié $\tilde{s}(t)$ de FID :

> - application d'une transformée de Fourier au module du signal S(t) complexe de FID et au module du signal modifié $\tilde{s}(t)$ de FID puis soustraction du spectre du module du signal S(t) au spectre du module du signal modifié $\tilde{s}(t)$ de FID ;
> - soustraction du résultat obtenu à l'étape précédente au spectre du module du signal modifié $\tilde{s}(t)$ de FID ;

- et le procédé comprend une étape d'identification et/ou de quantification des espèces à caractériser à partir du module du signal modifié $\tilde{s}(t)$ de FID au cours de laquelle on applique une transformée de Fourier à un signal comprenant au moins le module du signal modifié $\tilde{s}(t)$ de FID.

2. Procédé selon la revendication précédente, dans lequel la teneur de l'espèce de référence dans l'échantillon est suffisamment supérieure à la teneur de l'espèce à caractériser dans l'échantillon pour que le signal de l'espèce de référence fasse office de porteuse pour le signal de l'au moins une espèce à caractériser.

3. Procédé selon l'une quelconque des revendications 1 à 2, dans lequel au cours de l'étape d'acquisition (1330) on acquiert des signaux complexes S(t) de FID provenant de plusieurs voxels de l'échantillon, et dans lequel on effectue, après le calcul (340) du module du signal S(t) complexe de FID pour chacun des voxels, une étape de filtrage spatial.

4. Procédé selon l'une quelconque des revendications 1 à 2, dans lequel au cours de l'étape d'acquisition (310) on acquiert une pluralité de signaux complexes de décroissance libre d'induction (FID) et dans lequel après l'étape de génération (340) d'un module (222) de FID pour chaque signal S(t) complexe de FID de la pluralité de signaux S(t) complexes de FID, on effectue une sommation (350) des modules de FID pour obtenir un signal FID combiné et dans lequel on applique une transformée de Fourier (230) audit signal FID combiné.

5. Procédé selon l'une quelconque des revendications 1 à 2, dans lequel les antennes sont des bobines et dans lequel les signaux complexes de FID acquis proviennent de la même bobine.

6. Procédé selon l'une quelconque des revendications 1 à 4, dans lequel les antennes sont des bobines et dans lequel les signaux complexes de FID acquis proviennent de bobines différentes ou dans lequel les antennes sont des bobines et dans lequel les signaux complexes de FID acquis proviennent de bobines différentes et plusieurs signaux complexes de FID sont acquis pour au moins certaines bobines.

**7.** Procédé selon la revendication précédente, dans lequel après génération d'un module (222) de FID pour chaque signal complexe de FID, et avant sommation (350) des modules de FID pour obtenir un signal FID combiné, on effectue une étape de calcul d'un facteur de pondération (810) pour chaque bobine et on pondère chaque module (222) de FID par le facteur de pondération de la bobine dont il provient.

**8.** Procédé selon l'une quelconque des revendications 1 à 2, dans lequel au cours de l'étape d'acquisition (310, 1310) on acquiert un unique signal S(t) complexe de FID et dans lequel on applique une transformée de Fourier à un module (222) de FID obtenu par extraction du module de cet unique signal complexe de FID.

**9.** Procédé selon l'une quelconque des revendications 1 à 2, dans lequel au cours de l'étape d'acquisition (310, 1330) on acquiert un signal FID encodé spatialement, on répète cette acquisition plusieurs fois afin d'obtenir plusieurs signaux encodés, chacun desdits signaux encodés étant ensuite décodé de manière à ce qu'il soit associé à un voxel de l'échantillon et on génère un module (222) de FID pour le signal de FD associé à chaque voxel.

**10.** Procédé selon l'une quelconque des revendications précédentes, dans lequel l'échantillon est un échantillon de matière biologique, l'espèce de référence est de l'eau et les espèces à caractériser sont des métabolites ou dans lequel l'échantillon est une composition chimique, l'espèce de référence est un solvant et les espèces à caractériser sont des composés chimiques.

**11.** Procédé selon l'une quelconque des revendications précédentes, dans lequel le champ B0 constant est appliqué sur plusieurs voxels d'un échantillon et dans lequel les spectres des fréquences des signaux FID combinés des différents voxels sont utilisés pour générer une ou plusieurs images spectroscopiques.

**12.** Procédé selon l'une quelconque des revendications précédentes, dans lequel l'étape de fourniture de l'au moins un échantillon comprend une fourniture d'au moins un échantillon initial, et une modification de la composition de l'échantillon initial en effectuant au moins l'une des étapes suivantes :

- ajout de solvant dans une solution de l'échantillon initial pour augmenter la teneur du solvant et donc pour augmenter le signal de l'espèce de référence et lui faire pleinement jouer un rôle de porteuse;
- ajout dans l'échantillon initial d'une espèce ne produisant pas de signal, de préférence qui ne présente pas de fréquence de résonance, mais qui modifie les temps de relaxation.

**13.** Système de spectroscopie par résonance magnétique nucléaire (RMN) destiné à analyser par spectroscopie par RMN au moins un échantillon comprenant au moins une espèce à caractériser ainsi qu'une espèce de référence, la teneur de l'espèce de référence dans l'échantillon étant au moins supérieure à deux fois la teneur de l'au moins une espèce à caractériser, le système comprenant ledit échantillon et au moins une antenne configurée pour acquérir (310) un ou plusieurs signaux S(t) complexes de décroissance libre d'induction (FID) dans le domaine temporelle, chaque signal complexe de FID étant généré par application d'au moins un champ B0 sur l'au moins un échantillon et comprenant une partie réelle et une partie imaginaire, l'au moins un échantillon ayant été fourni de sorte que les teneurs relatives de l'espèce de référence et de l'au moins une espèce à caractériser ainsi que leurs temps relatifs de relaxation soient tels que dans chaque signal S(t) complexe de FID l'amplitude du signal de l'espèce de référence soit au moins deux fois supérieure à l'amplitude de celui de l'au moins une espèce à caractériser et de sorte que l'échantillon ne présente pas de signal de part et d'autre de la fréquence correspondant à celle de l'espèce de référence ; le système comprenant des moyens de traitement configurés de manière à :

- pour chaque signal complexe de FID, calculer le module (340) de chaque signal complexe de FID,
- identifier et/ou quantifier l'au moins une espèce à caractériser à partir du module chaque signal S(t) complexe de FID, selon les étapes correspondantes du procédé selon l'une quelconque des revendications 1 à 12.

**Patentansprüche**

**1.** Verfahren zur spektroskopischen Kernspinresonanz-Analyse (RMN) mindestens einer Probe, die eine zu charakterisierende Spezies und eine Referenz-Spezies umfasst, deren Gehalt in der Probe größer als zweimal dem Gehalt der mindestens einen zu charakterisierenden Spezies ist, wobei das Verfahren die folgenden Schritte umfasst:

a. Anwenden mindestens eines konstanten Feldes $B_0$ auf die mindestens eine Probe,
b. Erfassen (310, 1313) durch eine oder mehrere Antennen eines oder mehrerer komplexer Signale S(t) von freiem Induktionszerfall (FID), wobei jedes komplexe Signal S(t) von FID einen reellen Teil (140) und einen imaginären Teil (150) umfasst; wobei das Verfahren vor dem Erfassungsschritt einen Schritt des Bereitstellens der mindestens einen Probe umfasst, wobei der Bereitstellungsschritt derart ausgeführt wird, dass die relativen Gehalte der Referenz-Spezies und der mindestens einen zu charakterisierenden Spezies, sowie deren relative Erholungszeit derart sind, dass in jedem komplexen Signal S(t) von FID die Amplitude des Signals der Referenz-Spezies mindestens zweimal größer als die Amplitude von jenem der mindestens einen zu charakterisierenden Spezies ist;

**dadurch gekennzeichnet, dass**:

- der Schritt des Bereitstellens der Probe derart ausgeführt wird, dass die Probe kein Signal beiderseits der Frequenz aufweist, die jener der Referenz-Spezies entspricht; und

• das Verfahren entweder mindestens auch die folgenden Schritte umfasst:

- für jedes komplexe Signal S(t) von FID das Berechnen (340, 1314) des Moduls jedes komplexen Signals S(t) von FID;
- nach dem Berechnen (340) des Moduls jedes komplexen Signals S(t) von FID einen Schritt (230) des Anwendens einer Fourier-Transformation auf ein Signal unter Berücksichtigung des Moduls (222) von FID;
- Identifizieren der Art und des Gehalts der mindestens einen zu charakterisierenden Spezies aus dem Modul eines jeden komplexen Signals S(t) von FID;

• oder das Verfahren auch die folgenden Schritte nach dem Erfassungsschritt (310, 1313) durch eine oder mehrere Antennen mindestens eines komplexen Signals S(t) von FID umfasst:

- Erhalten (1323) eines Spektrums $S(\omega)$ von FID durch Anwenden einer Fourier-Transformation auf das reelle und komplexe Teil des mindestens einen komplexen Signals S(t) von FID, wobei das erhaltene Spektrum $S(\omega)$ von FID somit die Referenz-Spezies und die zu charakterisierende Spezies beinhaltet und zwei Abschnitte (UFR, DFR) aufweist, die sich jeweils aus der Resonanzfrequenz der Referenz-Spezies ($F_{0Ref}$) und jeweils beiderseits von $F_{0Ref}$ erstrecken, wobei mindestens eine Frequenz der zu charakterisierenden Spezies in einem ersten Abschnitt des Spektrums gelegen ist, das aus den beiden Abschnitten (UFR, DFR) angenommen wird;
- Modellierung (1321) des Signals der Referenz-Spezies Sref(t) aus dem reellen und komplexen Teil des mindestens einen komplexen Signals S(t) von FID;
- Erhalten (1322) eines Spektrum Sref($\omega$) der Referenz-Spezies durch Anwenden einer Fourier-Transformation auf die Modellierung des Signals der Referenz-Spezies Sref(t), wobei das Spektrum Sref($\omega$) der Referenz-Spezies somit zwei Spektrums-Abschnitte aufweist, die sich aus der Resonanzfrequenz der Referenz-Spezies ($F_{0Ref'}$) des Spektrums Sref($\omega$) erstrecken und sich jeweils beiderseits von $F_{0Ref'}$ erstrecken;
- Erhalten (1324) eines modifizierten Spektrums $\tilde{S}(\omega)$ von FID durch Substituieren eines zweiten Abschnitts des Spektrums $S(\omega)$ von FID, wobei der zweite Abschnitt der Abschnitt ist, der aus den beiden Abschnitten (UFR, DFR) des Spektrums $S(\omega)$ angenommen wird, und keine zu charakterisierende Spezies beinhaltet, durch den Abschnitt des Spektrums Sref($\omega$), der aus den beiden Abschnitten eines Spektrums angenommen wird, der sich aus $F_{0Ref'}$ des Spektrums Sref($\omega$) erstreckt und der sich auf derselben Seite wie der zweite Abschnitt des Spektrums $S(\omega)$ erstreckt;
- Anwenden (1325) einer inversen Fourier-Transformation zum modifizierten Spektrum $\tilde{S}(\omega)$, um in der Zeitdomäne ein modifiziertes Signal $\tilde{s}(t)$ von FID zu erhalten;
- Berechnen (1326) des Moduls des modifizierten Signals $\tilde{s}(t)$ von FID;
- Identifizieren der Art und des Gehalts der mindestens einen zu charakterisierenden Spezies aus dem Modul des modifizierten Signals $\tilde{s}(t)$ von FID;

° und das Verfahren die folgenden Schritte umfasst, die nach dem Berechnungsschritt (340, 1314) des Moduls eines jeden komplexen Signals S(t) von FID, nach dem Berechnungsschritt (1326) des Moduls des modifizierten Signals $\tilde{s}(t)$ von FID ausgeführt werden:

- Subtrahieren (1351) des Moduls des komplexen Signals S(t) von dem modifizierten Signal $\tilde{s}(t)$ von FID;

- Subtrahieren (1354) des in dem vorstehenden Schritt erhaltenen Ergebnisses von dem modifizierten Signal $\tilde{s}(t)$ von FID;
Oder

° das Verfahren die folgenden Schritte umfasst, die nach dem Berechnungsschritt (340, 1314) des Moduls eines jeden komplexen Signals S(t) von FID, nach dem Berechnungsschritt (1326) des Moduls des modifizierten Signals $\tilde{s}(t)$ von FID ausgeführt werden:

- Anwenden einer Fourier-Transformation auf das Modul des komplexen Signals S(t) von FID und auf das modifizierte Signal $\tilde{s}(t)$ von FID, danach Subtrahieren des Spektrums des Moduls des Signals S(t) vom Spektrum des Moduls des modifizierten Signals $\tilde{s}(t)$ von FID;
- Subtrahieren des in dem vorstehenden Schritt erhaltenen Ergebnisses von dem modifizierten Signal $\tilde{s}(t)$ von FID;
- und das Verfahren einen Schritt des Identifizierens und/ oder Quantisierens der zu charakterisierenden Spezies aus dem Modul des modifizierten Signals $\tilde{s}(t)$ von FID umfasst, im Laufe dessen eine Fourier-Transformation auf ein Signal angewandt wird, das mindestens das Modul des modifizierten Signals $\tilde{s}(t)$ von FID umfasst.

2. Verfahren nach dem vorstehenden Anspruch, wobei der Gehalt der Referenz-Spezies in der Probe ausreichend größer als der Gehalt der zu charakterisierenden Spezies in der Probe ist, damit das Signal der Referenz-Spezies als Träger für das Signal der mindestens einen zu charakterisierenden Spezies auftritt.

3. Verfahren nach einem der Ansprüche 1 bis 2, wobei im Laufe des Erfassungsschrittes (1330) komplexe Signale S(t) von FID erfasst werden, die aus mehreren Voxeln der Probe stammen, und wobei nach der Berechnung (340) des Moduls des komplexen Signals S(t) von FID für jedes der Voxel ein räumlicher Filterungsschritt ausgeführt wird.

4. Verfahren nach einem der Ansprüche 1 bis 2, wobei im Laufe des Erfassungsschrittes (1330) eine Vielzahl von komplexen Signalen von freiem Induktionszerfall (FID) erfasst werden, und wobei nach dem Schritt des Generierens (340) eines Moduls (222) von FID für jedes komplexe Signal S(t) von FID der Vielzahl von komplexen Signalen S(t) von FID eine Summierung (350) der Module von FID ausgeführt wird, um ein kombiniertes FID Signal zu erhalten, und wobei eine Fourier-Transformation (230) auf das kombinierte FID Signal angewandt wird.

5. Verfahren nach einem der Ansprüche 1 bis 2, wobei die Antennen Spulen sind, und wobei die erfassten komplexen Signale von FID aus derselben Spule stammen.

6. Verfahren nach einem der Ansprüche 1 bis 4, wobei die Antennen Spulen sind, und wobei die erfassten komplexen Signale von FID aus unterschiedlichen Spulen stammen, oder wobei die Antennen Spulen sind, und wobei die komplexen Signale von FID aus unterschiedlichen Spulen stammen und mehrere komplexe Signale von FID für mindestens bestimmte Spulen erfasst werden.

7. Verfahren nach dem vorstehenden Anspruch, wobei nach dem Generieren eines Moduls (222) von FID für jedes komplexe Signal von FID, und vor dem Summieren (350) der FID Module zum Erhalten eines kombinierten FID Signals ein Berechnungsschritt eines Gewichtungsfaktors (810) für jede Spule durchgeführt wird, und jedes Modul (222) von FID mit dem Gewichtungsfaktor der Spule gewichtet wird, aus der er stammt.

8. Verfahren nach einem der Ansprüche 1 bis 2, wobei im Laufe des Erfassungsschritts (310, 1310) ein einziges komplexes Signal S(t) von FID erfasst wird, und wobei eine Fourier-Transformation auf ein Modul (222) von FID angewandt wird, das durch Extrahieren des Moduls dieses einzigen komplexen Signals von FID erhalten wird.

9. Verfahren nach einem der Ansprüche 1 bis 2, wobei im Laufe des Erfassungsschritts (310, 1310) ein räumlich codiertes FID Signal erfasst wird, diese Erfassung mehrmals wiederholt wird, um mehrere codierte Signale zu erhalten, wobei jedes der codierten Signale danach decodiert wird, um einem Voxel der Probe zugewiesen zu werden, und ein Modul (222) von FID für das Signal von FD generiert wird, das jedem Voxel zugewiesen wird.

10. Verfahren nach einem der vorstehenden Ansprüche, wobei die Probe eine Probe aus biologischer Materie ist, wobei die Referenz-Spezies Wasser ist und die zu charakterisierenden Spezies Metaboliten sind, oder wobei die Probe eine chemische Verbindung ist, die Referenz-Spezies ein Lösungsmittel ist und die zu charakterisierenden Spezies chemische Zusammensetzungen sind.

**11.** Verfahren nach einem der vorstehenden Ansprüche, wobei das konstante Feld B0 auf mehrere Voxel einer Probe angewandt wird, und wobei die Spektren der Frequenzen der kombinierten FID Signale der verschiedenen Voxel verwendet werden, um ein oder mehrere spektroskopische Bilder zu generieren.

**12.** Verfahren nach einem der vorstehenden Ansprüche, wobei der Schritt des Bereitstellens der mindestens einen Probe ein Bereitstellen mindestens einer anfänglichen Probe umfasst, und eine Änderung der Zusammensetzung der anfänglichen Probe durch Ausführen mindestens eines der folgenden Schritte:

- Beigeben von Lösungsmittel in eine Lösung der anfänglichen Probe zum Erhöhen des Gehalts des Lösungsmittels und somit zum Erhöhen des Signals der Referenz-Spezies und um sie vollständig eine Trägerrolle spielen zu lassen;
- Beigeben in die anfängliche Probe einer Spezies, die kein Signal erzeugt, vorzugsweise keine Resonanzfrequenz aufweist, aber die Erholungszeit modifiziert.

**13.** System zur spektroskopischen Kernspinresonanz-Analyse (RMN), das dazu bestimmt ist, mindestens eine Probe durch Spektroskopie durch RMN zu analysieren, die mindestens eine zu charakterisierende Spezies, sowie eine Referenz-Spezies umfasst, wobei der Gehalt der Referenz-Spezies in der Probe mindestens größer als zweimal dem Gehalt der mindestens einen zu charakterisierenden Spezies ist, wobei das System die Probe und mindestens eine Antenne umfasst, die konfiguriert ist, um ein oder mehrere komplexe Signale S(t) von freiem Induktionszerfall (FID) in der Zeitdomäne zu erfassen, wobei jedes komplexe Signal von FID durch Anwenden mindestens eines Feldes B0 auf mindestens eine Probe generiert wird, und einen reellen und einen imaginären Teil umfasst, wobei die mindestens eine Probe derart bereitgestellt worden ist, dass die relativen Gehalte der Referenz-Spezies und der mindestens einen zu charakterisierenden Spezies, sowie deren relative Erholungszeit derart sind, dass in jedem komplexen Signal S(t) von FID die Amplitude des Signals der Referenz-Spezies mindestens zweimal größer als die Amplitude von jenem der mindestens einen zu charakterisierenden Spezies ist, und derart, dass die Probe kein Signal beiderseits der Frequenz aufweist, die jener der Referenz-Spezies entspricht; wobei das System Bearbeitungsmittel umfasst, die konfiguriert sind, um:

- für jedes komplexe Signal von FID das Modul (340) jedes komplexen Signals von FID zu berechnen,
- die mindestens eine zu charakterisierende Spezies aus dem Modul jedes komplexen Signals S(t) von FID gemäß den entsprechenden Schritten des Verfahrens nach einem der Ansprüche 1 bis 12 zu identifizieren und/ oder zu quantisieren.

**Claims**

**1.** Method for the spectroscopic analysis, by nuclear magnetic resonance (NMR), of at least one sample comprising at least one species to be characterised as well as a reference species the content whereof in the sample is more than twice the content of the at least one species to be characterised, the method comprising the following steps:

a. applying at least one constant field $B_0$ to the at least one sample,
b. acquiring (310, 1313), by one or more antennas, one or more complex free induction decay (FID) signals S(t), each complex FID signal S(t) comprising a real part (140) and an imaginary part (150); the method comprising, prior to the acquisition step, a step of supplying the at least one sample, the supply step being carried out such that the relative contents of the reference species and of the at least one species to be characterised, as well as the relative relaxation times thereof, are such that, in each complex FID signal S(t), the amplitude of the signal of the reference species is at least twice the amplitude of that of the at least one species to be characterised;

**characterised in that**:

- the step of supplying the sample is carried out such that the sample has no signal on either side of the frequency corresponding to that of the reference species; and

• either the method further comprises at least the following steps of:

- for each complex FID signal S(t), calculating (340, 1314) the modulus of each complex FID signal S(t);
- after calculating (340) the modulus of each complex FID signal S(t), a step (230) of applying a Fourier transform to a signal taking into account said FID modulus (222);
- identifying the nature and the content of the at least one species to be characterised from the modulus of each complex FID signal S(t);

• or the method further comprises the following steps, carried out after the step of acquiring (310, 1313), by one or more antennas, at least one complex FID signal S(t):

- obtaining (1323) an FID spectrum $S(\omega)$ by applying a Fourier transform to the real and complex parts of the at least one complex FID signal S(t), the FID spectrum S(w) obtained thus including the reference species and the species to be characterised and having two portions (UFR, DFR), each extending from the resonance frequency of the reference species ($F_{0Ref}$) and respectively on either side of $F_{0Ref}$, at least one frequency of the species to be characterised being situated on a first portion of spectrum taken from among said two portions (UFR, DFR);
- modelling (1321) the signal of the reference species Sref(t) from the real and complex parts of the at least one complex FID signal S(t);
- obtaining (1322) a spectrum Sref($\omega$) of the reference species by applying a Fourier transform to the modelling of the signal of the reference species Sref(t), the spectrum Sref($\omega$) of the reference species thus having two spectrum portions extending from the resonance frequency of the reference species ($F_{0Ref}$) of the spectrum Sref($\omega$) and extending on either side of $F_{0Ref}$ respectively;
- obtaining (1324) a modified FID spectrum $\tilde{S}(\omega)$, by substituting a second portion of the FID spectrum $S(\omega)$, said second portion being the portion taken from among said two portions (UFR and DFR) of the spectrum $S(\omega)$ and which does not include the species to be characterised, with the portion of the spectrum Sref($\omega$) taken from among the two spectrum portions extending from $F_{0Ref}$ of the spectrum Sref($\omega$) and which extends on the same side as said second portion of the spectrum $S(\omega)$;
- applying (1325) an inverse Fourier transform to the modified spectrum $\tilde{S}(\omega)$ to obtain a modified FID signal $\tilde{s}(t)$ in the time domain;
- calculating (1326) the modulus of the modified FID signal $\tilde{s}(t)$;
- identifying the nature and the content of the at least one species to be characterised from the modulus of the modified FID signal $\tilde{s}(t)$;

  ◦ and the method comprises the following steps, carried out after the step of calculating (340, 1314) the modulus of each complex FID signal S(t), after the step of calculating (1326) the modulus of the modified FID signal $\tilde{s}(t)$:

    - subtracting (1351) the modulus of the complex FID signal S(t) from the modulus of the modified FID signal $\tilde{s}(t)$;
    - subtracting (1354) the result obtained in the previous step from the modulus of the modified FID signal $\tilde{s}(t)$;
    or

  ◦ the method comprises the following steps, carried out after the step of calculating (340, 1314) the modulus of each complex FID signal S(t), after the step of calculating (1326) the modulus of the modified FID signal $\tilde{s}(t)$:

    - applying a Fourier transform to the modulus of the complex FID signal S(t) and to the modulus of the modified FID signal $\tilde{s}(t)$ and then subtracting the spectrum of the modulus of the signal S(t) from the spectrum of the modulus of the modified FID signal $\tilde{s}(t)$;
    - subtracting the result obtained in the previous step from the spectrum of the modulus of the modified FID signal $\tilde{s}(t)$;
    - and the method comprises a step of identifying and/or quantifying the species to be characterized from the modulus of the modified FID signal $\tilde{s}(t)$, wherein a Fourier transform is applied to a signal comprising at least the modulus of the modified FID signal $\tilde{s}(t)$.

2. Method according to the preceding claim, wherein the content of the reference species in the sample is sufficiently greater than the content of the species to be **characterised in** the sample for the signal of the reference species to act as a carrier for the signal of the at least one species to be characterised.

3. Method according to any one of claims 1 to 2, wherein during the acquisition step (1330) complex FID signals S(t) are acquired from a plurality of voxels of the sample, and wherein after calculating (340) the modulus of the complex FID signal S(t) for each of the voxels, a spatial filtering step is carried out.

4.  Method according to any one of claims 1 to 2, wherein during the acquisition step (310) a plurality of complex free induction decay (FID) signals are acquired and wherein after the step of generating (340) an FID modulus (222) for each complex FID signal S(t) of the plurality of complex FID signals S(t), a summation (350) of the FID moduli is carried out to obtain a combined FID signal and wherein a Fourier transform (230) is applied to said combined FID signal.

5.  Method according to any one of claims 1 to 2, wherein the antennas are coils and wherein the complex FID signals acquired originate from the same coil.

6.  Method according to any one of claims 1 to 4, wherein the antennas are coils and wherein the acquired complex FID signals originate from different coils or wherein the antennas are coils and wherein the acquired complex FID signals originate from different coils and a plurality of complex FID signals are acquired for at least some coils.

7.  Method according to the preceding claim, wherein after generating an FID modulus (222) for each complex FID signal, and before summing (350) the FID moduli to obtain a combined FID signal, a step of calculating a weighting factor (810) for each coil is carried out and each FID modulus (222) is weighted by the weighting factor of the coil from which it originates.

8.  Method according to any one of claims 1 to 2, wherein during the acquisition step (310, 1310), a single complex FID signal S(t) is acquired and wherein a Fourier transform is applied to an FID modulus (222) obtained by extracting the modulus of this single complex FID signal.

9.  Method according to any one of claims 1 to 2, wherein during the acquisition step (310, 1330), a spatially encoded FID signal is acquired, this acquisition is repeated a plurality of times to obtain a plurality of encoded signals, each of said encoded signals then being decoded such that it is associated with a voxel of the sample, and an FID modulus (222) is generated for the FID signal associated with each voxel.

10. Method according to any one of the preceding claims, wherein the sample is a sample of biological material, the reference species is water and the species to be characterised are metabolites or wherein the sample is a chemical composition, the reference species is a solvent and the species to be characterised are chemical compounds.

11. Method according to any one of the preceding claims, wherein the constant field B0 is applied to a plurality of voxels of a sample and wherein the frequency spectra of the combined FID signals of the different voxels are used to generate one or more spectroscopic images.

12. Method according to any one of the preceding claims, wherein the step of supplying the at least one sample comprises supplying at least one initial sample, and modifying the composition of the initial sample by carrying out at least one of the following steps of:

    - adding solvent to a solution of the initial sample to increase the solvent content and thus increase the signal of the reference species and make it act decidedly as a carrier;
    - adding a non-signal producing species to the initial sample, preferably one that does not have a resonance frequency, but that changes the relaxation times.

13. Nuclear magnetic resonance (NMR) spectroscopy system intended to analyse, by NMR spectroscopy, at least one sample comprising at least one species to be characterised as well as a reference species, the content of the reference species in the sample being at least twice the content of the at least one species to be characterised, the system comprising said sample and at least one antenna configured to acquire (310) one or more complex free induction decay (FID) signals S(t) in the time domain, each complex FID signal being generated by applying at least one field B0 to the at least one sample and comprising a real part and an imaginary part, the at least one sample having been supplied such that the relative contents of the reference species and of the at least one species to be characterised, as well as the relative relaxation times thereof, are such that in each complex FID signal S(t), the amplitude of the signal of the reference species is at least twice the amplitude of that of the at least one species to be characterised and such that the sample has no signal on either side of the frequency corresponding to that of the reference species; the system comprising processing means configured to:

- for each complex FID signal, calculate the modulus (340) of each complex FID signal,
- identify and/or quantify the at least one species to be characterised from the modulus of each complex FID signal S(t), according to the corresponding steps of the method according to any one of claims 1 to 12.

Figure 1

Figure 2

Figure 3

Figure 4

Figure 5

Figure 6

Figure 7

101 ⟋1201

FID Partie Imaginaire
FID Partie Réelle

102 ⟋1202

FID Partie Imaginaire
FID Partie Réelle

FID Antenne 102 FID Antenne 101
Parties Réelle    Parties Réelle
et Imaginaire    et Imaginaire

340

Calcul du Module

340

Calcul du Module

Correction de Phase

Correction de l'Amplitude

810

Correction de l'Amplitude

320

Sommation Parties Réelles

330

Sommation Parties Imaginaires

350

Sommation des Modules

Transformée de Fourier Complexe

230

Transformée de Fourier du Module

Correction de Fréquence

Continuation du Traitement des Signaux pour l'Application Considérée

Figure 8

910

Traitement du
Module

920

Traitement
conventionnel

Figure 9

Figure 10a

S/N=164

Figure 10b

Figure 11a

Figure 11b

S/N=231

1110

Figure 11c

Figure 12a

Figure 12b

Figure 12c

Figure 12d

Figure 12e

Figure 12f

Figure 13

Figure 14

Pas de filtrage temporel | Filtrage temporel exponentiel

a Conventionnel: SNR=49
b Module: SNR=32
c DFRR: SNR=47
d (Module+DFRR)+const: SNR=47

e Conventionnel: SNR=84
f Module : SNR=71
g DFRR: SNR=106
h (Module+DFRR)+const: SNR=84

Figure 15

EP 2 939 046 B1

Figure 16

1710

1720

Figure 17

1810

1820

Figure 18

α = 0, SNR = 47/49

1910

α = 10, SNR = 76/96

1920

α = 20, SNR = 102/129

1930

α = 40, SNR = 156/175

1940

Figure 19

Figure 20

Figure 21

EP 2 939 046 B1

Données brutes: $CSI\left(k_x, k_y, k_z, t\right)$ — 1330

Post traitement spatial
Filtrage spatial → $CSI\left(x, y, z, t\right)$
→ CSI (x,y,z,t)

Traitement du Module — 1310

Extraction FID → $s\left(t\right)$ — 1313

DFRR + traitement du module

HLSVD → $h_2o\left(t\right)$ — 1321

FFT → $H_2O\left(\omega\right)$ — 1322

FFT → $S\left(\omega\right)$ — 1323

DFRR → $\tilde{S}\left(\omega\right)$ — 1324

iFFT → $\tilde{s}\left(t\right)$ — 1325

Module → $\tilde{s}_{Mod}\left(t\right)$ — 1326

Module → $s_{Mod}\left(t\right)$ — 1314

Filtrage temporel

Figure 22

Figure 23

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 20040095139 A

- US 2008204022 A

**Littérature non-brevet citée dans la description**

- Compensation of Magnetic Field Instabilities in Field Cycling NMR by Reference Deconvolution. **STEFAN REUTTER et al.** APPLIED MAGNETIC RESONANCE. SPRINGER VIENNA, 05 Octobre 2012, vol. 44, 55-63

- Desktop fast-field cycling nuclear magnetic resonance relaxometer. **MESQUITA SOUSA D et al.** SOLID STATE NUCLEAR MAGNETIC RESONANCE. ELSEVIER SCIENCE BV, 16 Juillet 2010, vol. 38, 36-43
- **PIJNAPPEL ; VAN DEN BOOGAART ; DE BEER ; VAN ORMONDT.** SVD-Based Quantification of Magnetic Resonance Signals. *Journal of Magnetic Resonance,* 1992, vol. 97, 122-134